# EUROPEAN PATENT SPECIFICATION

(11) **EP 4 682 778 B1**
(45) Date of publication and mention of the grant of the patent: **18.11.2026**
(21) Application number: 25218995.6
(22) Date of filing: 31.12.2021
(51) Int. Cl.: G06N 10/40, G06N 10/70, G06N 10/20

(54) **NON-LINEAR SUPERCONDUCTING QUANTUM CIRCUIT**
NICHTLINEARE SUPRALEITENDE QUANTENSCHALTUNG
CIRCUIT QUANTIQUE SUPRACONDUCTEUR NON LINÉAIRE

(43) Date of publication of application: 21.01.2026
(62) Document number(s) of the earlier application(s) in accordance with Art. 76 EPC: 21306965.1 / 4 207 005
(73) Proprietor: Alice & Bob, 75015 Paris (FR)
(72) Inventor: LESCANNE, Raphaël, 75015 PARIS (FR)
(74) Representative: Atout PI Laplace

(56) References cited:
- WO-A1-2020/150348
- US-A1- 2021 234 086
- LESCANNE RAPHAËL ET AL: "Exponential suppression of bit-flips in a qubit encoded in an oscillator", vol. 16, no. 5, 26 July 2019 (2019-07-26), GB, pages 1 - 18, XP055927392, ISSN: 1745-2473, Retrieved from the Internet <URL:https://cas.mines-paristech.fr/~leghtas/papers/Lescanne-al-arXiv_2019b.pdf> [retrieved on 20220602], DOI: 10.1038/s41567-020-0824-x
- BERDOU C ET AL: "One hundred second bit-flip time in a two-photon dissipative oscillator", ARXIV.ORG, CORNELL UNIVERSITY LIBRARY, 201 OLIN LIBRARY CORNELL UNIVERSITY ITHACA, NY 14853, 19 April 2022 (2022-04-19), XP091206189
- RONAN GAUTIER ET AL: "Combined Dissipative and Hamiltonian Confinement of Cat Qubits", ARXIV.ORG, CORNELL UNIVERSITY LIBRARY, 201 OLIN LIBRARY CORNELL UNIVERSITY ITHACA, NY 14853, 24 January 2022 (2022-01-24), XP091131098

## Description

### TECHNICAL FIELD

The present disclosure relates to the field of quantum technologies, and more specifically to a superconducting quantum circuit, a device comprising such a circuit, a quantum computing system comprising such a circuit, and a method involving such a circuit.

### BACKGROUND

There has been growing attention in recent years for developing quantum technologies for several applications, such as quantum computation and communication. In particular, superconducting quantum circuits are a promising platform for realizing quantum computation with so called cat qubits. In this specific context, superconducting quantum circuits are engineered to exhibit specific quantum dynamics, such as stabilizing a quantum manifold of coherent states. The stabilization of a quantum manifold of coherent states has been studied notably in the following articles:
- *"*Exponential suppression of bit-flips in a qubit encoded in an oscillator", Lescanne R. et. al., Nature Physics, 2020;
- *"*Coherent Oscillations inside a Quantum Manifold Stabilized by Dissipation", Touzard S. et. al.; Physical Review X, 2018; and
- *"*Confining the state of light to a quantum manifold by engineered two-photon loss". Leghtas Z. et. al., Science, 2015.

Said stabilization requires to engineer a non-linear conversion between two photons of a first mode that hosts the stabilized quantum manifold and one photon of a second mode known as buffer mode. To achieve the non-linear conversion, existing solutions comprise applying external time-varying excitations on the superconducting quantum circuit, in the form of one or more microwave tones at specific frequencies called parametric pumps, in order to bridge the energy gap between the energy of two photons of the first mode and one photon of the second mode. These solutions are also known as parametric pumping techniques.

Within this context, there is still need for an improved superconducting quantum circuit to engineer the non-linear conversion.

### SUMMARY

The invention is defined by the independent claims.

Preferred embodiments are defined by the dependent claims.

### BRIEF DESCRIPTION OF THE DRAWINGS

Non-limiting examples will now be described in reference to the accompanying drawings, where:
- FIG. 1 illustrates how the circuit is incorporated in a device in order to stabilize quantum information.
- FIG. 2 illustrates various examples of circuits used to isolate the first mode from the environment.
- FIG. 3 illustrates examples of how to use the circuit incorporated in a device in order to stabilize quantum information.
- FIG.s 4a and 4b illustrate how the current is tuned to reach the frequency matching condition.
- FIG. 5 illustrates several examples of circuit symbolic representations alternatively used throughout this description.
- FIG. 6 illustrates one embodiment of the superconducting circuit.
- FIG. 7 illustrates another embodiment of the superconducting circuit.
- FIG. 8 illustrates another embodiment of the superconducting circuit.
- FIG. 9 illustrates experimental data that were obtained with an example of the circuit.

### DETAILED DESCRIPTION

It is provided a superconducting quantum circuit having a first mode and a second mode. Each of the first mode and the second mode has a respective resonant frequency. The circuit is configured such that the resonant frequency of the second mode is substantially 2N times the resonant frequency of the first mode when a predetermined current of a constant intensity is applied to the circuit. The circuit thus performs intrinsically a resonant 2N-to-1 photon exchange between respectively the first mode and the second mode. N is a positive integer (that is, N is any positive integer larger or equal than 1), and thus 2N is an even number, e.g., 2, 4, 6 or more. Hence, the expression "2N photons" means a discrete (and even) quantity of photons defined by the integer 2N.

Such a superconducting quantum circuit improves the resonant 2N-to-1 photon exchange between respectively the first mode and the second mode. Indeed, in the superconducting quantum circuit, the resonant frequency of the second mode is substantially 2N times the resonant frequency of the first mode when a predetermined current of a constant intensity is applied to the circuit. This is in contrast to prior art, where external time-varying excitations (such as those performed by parametric pumping techniques) are used to bridge the gap between the frequencies of the two modes and perform the resonant 2N-to-1 photon exchange. The external time-varying excitation used in such prior art relaxes the constraint on the modes frequencies but induces undesired effects such as heating the modes. This heating reduces coherence times of the circuit and causes instabilities of the dynamics. This results in that any non-linear mixing, including the resonant 2N-to-1 photon exchange is ultimately destroyed. In this respect, the absence of external time-varying excitation enables increasing the rate of the resonant 2N-to-1 photon exchange by one or two orders of magnitude compared to prior art.

The superconducting quantum circuit has a first mode and a second mode. The first mode and the second mode may each correspond to natural resonance frequencies of the circuit. For example, each of the first mode and the second mode may be either an electromagnetic mode or a mechanical mode. Each of the first mode and the second mode may have a respective natural resonance frequency. For example the first mode (respectively the second mode) may be a mechanical mode and the second mode may be an electromagnetic mode (respectively the first mode being an electromagnetic mode). The first mechanical mode and the second electromagnetic mode may be coupled in the circuit via the piezo-electric effect. Each of the first mode and the second mode may have a respective resonant frequency, e.g., the first mode may have a resonant frequency of the type ${f}_{a} = \frac{{ω}_{a}}{2 π}$ and the second mode may have a resonant frequency of the type ${f}_{b} = \frac{{ω}_{b}}{2 π}$, where *ωₐ* and *ω_{b}* may be the angular frequencies of each respective mode. By "having" a first mode and a second mode, it is meant that the superconducting quantum circuit may comprise components, operating in a superconducting regime, which host the modes, independently of each other or concurrently. In other words, the first mode and the second mode may be hosted in different subsets of components of the superconducting circuit or (alternatively) on the same subset of components.

The superconducting quantum circuit may be operated at temperatures close to absolute zero (e.g., 100 millikelvins or less, typically 10mK), and isolated as much as possible from the environment to avoid energy loss and decoherence, except for some tailored couplings. For example, only the second mode may be coupled to a dissipative environment, while the first mode may remain isolated from the environment.

The superconducting quantum circuit may be manufactured as one or more patterned layers of superconducting material (e.g. aluminum, tantalum, niobium among others, as known in the art) deposited on a dielectric substrate (e.g. silicon, sapphire among others). Each of the one or more patterned layers may define lumped element resonators. A capacitive element may be formed (on a respective layer of the one or more patterned layers) with two neighboring plates of superconducting material. An inductive element may be formed with a superconducting wire. Alternatively, at least one of the one or more patterned layers may define portions of transmission lines each resonating at a frequency which depending of their length. The transmission lines may be, for example, co-planar wave guides or microstrip lines. Yet alternatively, the circuit may be embedded in a 3D architecture which comprises high quality 3D modes machined or micro-machined into bulk superconductor that can be used as any of the two modes.

The non-linear circuit and the predetermined current of a constant intensity are configured such that, when said predetermined current is applied to the circuit, the resonant frequency of the second mode of the circuit is substantially 2N times the resonant frequency of the first mode (also called a "frequency matching condition" of the form *2Nfₐ = f_{b}, fₐ* being the resonant frequency of the first mode and *f_{b}* being the resonant frequency of the second mode, or equivalently of the form *2Nωₐ* = *ω_{b}*). In other words, the predetermined current is an external current which induces an internal DC (direct current) bias to the circuit. The internal current is adapted so that the components/hardware forming the circuit are in a specific regime: namely, that the respective resonant frequency of the second mode (also called second resonant frequency) of the circuit is substantially 2N times the respective resonant frequency of the first mode (also called first resonant frequency). Thus, the non-linearity of the circuit performs intrinsically the resonant 2N-to-1 photon exchange that destroys 2N photons in the first mode (at the first resonant frequency) while creating one photon in the second mode (at the second resonant frequency), and conversely destroys one photon in the second mode (at the second resonant frequency) while creating 2N photons in the first mode (at the first resonant frequency). Indeed, the resonant 2N-to-1 photon exchange may be performed at a given rate, e.g., denoted *g*_{2*N*}. The exchange of photons among the two modes may be mediated via elements (e.g., non-linear elements) of the circuit. The predetermined current is applied so that the frequency matching condition of the type 2*Nωₐ = ω_{b}* occurs, and so that the circuit performs the resonant 2N-to-1 photon exchange dynamics. The predetermined current at which the frequency matching condition is reached is also called the bias point of the circuit. The bias point may also be called an optimal bias point if the choice of the circuit parameters make spurious dynamics vanish at the frequency matching condition, as shown in examples below.

The predetermined current may be applied directly (that is, galvanically) to the circuit so that it flows through at least a subset of elements of the circuit and gets divided in the various possible branches. The currents that flow in the branches of the circuit are called internal currents and are determined according to Kirchhoff's current laws. In examples, the predetermined current may be applied directly via a current source, connected to the circuit. In examples, the circuit may have a planar geometry, and thus the path of the predetermined current merges with a portion of the superconducting loop in the same planar geometry, e.g., an on-chip current path.

Alternatively, the predetermined current may be applied indirectly, that is, an internal current may be induced in the circuit through a mutual inductance (for example, with a coil). In other words, an external inductance is inductively coupled to the circuit via a shared mutual inductance so as to induce a current in the circuit so that it flows through at least a subset of elements of the circuit. Thus, the internal current is the current induced into the circuit via the mutual inductance. Since there is no need for a direct (galvanic) connection with the circuit, the predetermined current path may be either on the same level as the circuit, or made of an external coil above or below the circuit, the axis of which being perpendicular to the superconducting circuit plane. In examples, when the mutual inductance is shared with a coil, the later may be formed with multiple turns of a material that allows the circulation of current in order to generate of a magnetic field. The coil may be made of any number of coils needed; this increases the mutual inductance. The coil may be made of any material that allows circulation of current in order to generate of a magnetic field and in turn induce the internal current; for instance, the coil may be made of a superconducting material or a non superconducting material. Alternatively, the coil may be replaced by a permanent magnet that directly generates a constant magnetic. However, this makes the tuning of the magnetic field unpractical.

The application of the predetermined current results in a given internal current *I_{DC}* that flows through a subset of inductive elements and, in given superconducting phase drops *φ_{DC}* that develops across each inductive element. The phase drop *φ_{DC}* may be computed given the circuit geometry and parameters as a function of the predetermined current. Examples below illustrate how the predetermined current may be experimentally tuned (or equivalently the superconducting phase-drop *φ_{DC}*) to reach the bias point and thereby enable the resonant 2N-to-1 photon exchange dynamics. Thus, the application of the current is adapted to the configuration of the circuit so as to yield the intrinsic resonant 2N-to-1 photon exchange.

The provided circuit performs intrinsically a resonant 2N-to-1 photon exchange. In other words, the circuit is configured to perform the resonant 2N-to-1 photon exchange autonomously/natively, that is, without requiring an external time-varying excitation to bridge the gap between 2N times the frequency of the first mode and the frequency of the second mode to achieve the resonant 2N-to-1 photon exchange. In other words, the value of the predetermined current is set so that the components hosting the first and second modes (performing the exchange) are in a regime allowing the resonant 2N-to-1 photon exchange. That is, there is no dependence on any microwave devices external to the circuit, such as a parametric pump. A resonant 2N-to-1 photon exchange between respectively the first mode and the second mode is a quantum dynamic that destroys 2N photons of the first mode at the respective resonant frequency of the first mode, and creates one photon of the second mode at the respective resonant frequency of the second mode and conversely. Said resonant 2N-to-1 photon exchange is performed when the resonant frequency of the second mode is substantially 2N times the frequency of the resonant first mode, by applying the predetermined current of a constant intensity to the circuit. By "substantially", it is meant that the value of the predetermined current is such that the frequency of the second mode is equal to 2N times the frequency of the first mode (also called a frequency matching condition in some applications) up-to a predetermined threshold of the same order of magnitude as the resonant 2N-to-1 photon exchange rate *g*_{2*N*}.

As the superconducting quantum circuit performs said quantum dynamics intrinsically, this eliminates the need of a parametric pump, as the exchange is reliably performed by the circuit, which comprises components configured to operate in the superconducting regime allowing the intrinsic resonant 2N-to-1 photon exchange. Hence, the quality of the resonant 2N-to-1 photon exchange is improved. The absence of the parametric pump eliminates the apparition of detrimental parasitic interactions that affect the quality of the resonant 2N-to-1 photon exchange.

The circuit may be integrated into a device which may also comprise a current source configured to apply the predetermined current of a constant intensity to the circuit such that the frequency of the second mode is substantially 2N times the frequency of the first mode. The current source may be directly connected or inductively coupled to the circuit, so that the induced internal current traverses at least some (e.g., all) the elements of the circuit. In other words, the applied current may induce an internal current moving through the surface of the circuit, in specific elements of the circuit. The current source is an apparatus that may be placed at room temperature, and thus not comprising superconducting elements. The current source may apply the predetermined current to the circuit first via conducting wires at room temperature, which are in turn connected, as the temperature decreases, to superconducting wires that apply the current to the superconducting circuit. The current may also be filtered using a low pass filter along its path in order to reduce the impact of low frequency noise.

In examples, the device may further comprise a load, a microwave source and a coupler. The coupler may be configured to connect the second mode of the superconducting quantum circuit to the load. The load is a dissipative element (e.g., an element with a given resistance, contrary to a superconducting element) that is external to the superconducting circuit. The load dissipates photons exchanged from the first mode to the second mode through the resonant 2N-to-1 photon exchange. In other words, photons destroyed from the first mode are evacuated through the second mode, via the load, to the environment. The microwave source may be configured to apply a microwave radiation at a frequency substantially equal to the frequency of the second mode or (equivalently) at a frequency substantially equal to 2N times the frequency of the first mode. In other words, the microwave source may be configured to control the microwave radiation in amplitude and phase. The microwave source thus drives photons (in the form of the microwave radiation) into the second mode which in turns drives 2N photons in the first mode through the resonant 2N-to-1 photon exchange. The coupler is an element, which may be connected (e.g., galvanically, capacitively or inductively) to elements of the circuit hosting the second mode, and mediating the interaction between the second mode and the load and the microwave source.

Optionally, the coupler may also be configured for coupling the elements of the circuit hosting the second mode of the superconducting quantum circuit to the load and to the microwave source.

The load may be a resistor, a matched transmission line or a matched waveguide. By "matched" it is meant that the transmission line or the waveguide are terminated by an appropriate resistance at an end different from the end connected to the elements hosting the second mode. The load may be comprised within the microwave source.

In examples, this microwave source may be placed a room temperature and connected to the circuit via coaxial cables. In examples, attenuators may be placed between the microwave source and the circuit (that is, along the path of the microwave radiation applied by the microwave source) to thermalize the microwave radiation with the cryogenic environment. This allows to apply the microwave radiation without added noise. This microwave radiation does not serve the same purpose as a parametric pump and is not required to obtain the resonant 2N-to-1 photon exchange dynamics. Here, the dissipation from the load, the microwave radiation and the resonant 2N-to-1 photon exchange dynamics (intrinsically performed by the circuit) are used together to stabilize 2N coherent states in the first mode. Indeed, without the microwave radiation, only vacuum would be stabilized in the first mode. In other words, the device allows the stabilization of a quantum manifold of coherent states beyond the vacuum.

Optionally, the device may comprise a band pass or a band stop filter connected to the first mode and the second mode of the circuit. The band pass or the band stop filter may be configured for only allowing the coupling of the second mode to the load. Optionally, the device may also comprise a microwave filter in order to protect the first mode from dissipating in the load. This microwave filter may be interleaved between the load and the coupler. From the point of view of the circuit this filter has to prevent the microwave photons at the first resonant frequency to escape the circuit. This can either be by realising a band stop filter at the first resonant frequency or by realising a band pass filter at the second resonant frequency as the photon of the second mode are the only ones that need to dissipate in the environment. For some circuits, in which the two modes have different symmetries the filter may not be required and the proper symmetry of the coupler may be sufficient to prevent the dissipation of the first mode.

Thus, the device enables the stabilisation of 2N coherent states in the first mode (that is, a quantum manifold of coherent states). For example, the microwave source applying the microwave radiation to the second mode through the microwave filter may be seen as a 2N photon drive of the first mode once converted by the resonant 2N-to-1 photon exchange, and the load that dissipates photons of the second mode only may be seen as a 2N photon dissipation of the first mode once converted by the resonant 2N-to-1 photon exchange. The 2N photon drive and 2N photon dissipation enables the stabilisation of 2N coherent states in the first mode.

It is further provided a method. The method comprises providing the superconducting quantum circuit. The method also comprises applying a predetermined current of a constant intensity to the circuit (or the device comprising the circuit) such that the resonant frequency of the second mode is substantially 2N times the resonant frequency of the first mode, N being a positive integer which effectively engineers a resonant 2N-to-1 photon exchange between the two modes respectively.

The method further comprises using the device in order to stabilize a quantum manifold spanned by 2N coherent states, each having the same amplitude and a *π*/*N* phase difference between each other. This is done by combining the resonant 2N-to-1 photon exchange dynamics provided by the circuit with external dissipation and microwave radiation. Quantum information may eventually be encoded in this quantum manifold, as a so-called cat-qubit.

It is further provided a quantum computing system. The quantum computing system may comprise at least one of the superconducting quantum circuit and/or the device. The quantum computing system may be configured to use the superconducting quantum circuit and/or the device for performing high quality quantum computation protocols. In other words, the quantum system may use the superconducting quantum circuit and/or the device for performing fault-tolerant quantum computation. This is made possible thanks to the fact that the intrinsic resonant 2N-to-1 photon exchange dynamics combined with external dissipation and microwave radiation stabilizes a quantum manifold spanned by 2N coherent states of the first mode, also called "cat-qubit states" in some applications. In this quantum manifold, the 2N coherent states have the same amplitude and there is a phase difference of *π*/*N* among each coherent state. The quantum computing system may use these coherent states to define logical qubits, which are naturally protected to errors thanks to the quantum manifold being stable, notably against bit flip errors. The quantum system may thus define operations (e.g., CNOT, Hadamard and/or Toffoli gates), which perform computations on the logical qubits. This opens up a full paradigm for implementing quantum algorithms in a fault tolerant manner.

The circuit is now discussed in more details.

The circuit may have, when the predetermined current is applied to the circuit, a specific Hamiltonian. As known in the field, a Hamiltonian is an operator corresponding to the total energy of the superconducting circuit, e.g., including both the kinetic energy and potential energy. The Hamiltonian may be used to compute the time evolution of the circuit. The Hamiltonian may be engineered so as to exhibit desired quantum dynamics, notably, the resonant 2N-to-1 photon exchange between respectively the first mode and the second mode. The Hamiltonian of the circuit is herein a function of a specific set of parameters of the superconducting quantum circuit and parameter of the predetermined current. By "parameter" it is meant any kind of physical parameter of the circuit and/or the predetermined current such as, e.g., capacitance, inductance, resistance, frequency, phase difference, energy levels, zero-point fluctuations of phase, Josephson energy or critical current, and other parameters such as voltage and/or current levels (e.g., a direct current (DC) bias) from the applied predetermined current. The set of parameters is specific in that it consists of parameters of the circuit and parameters of the predetermined current. In other words, the Hamiltonian does not depend on any other parameter than those specific parameters. Yet in other words, the Hamiltonian depends on, and only on, the circuit and on the predetermined current. For the sake of explanation, the set of parameters may be denoted as a set P1 U P2, where U designates a union operator. The set of parameters P1 consists (only) of parameters of the circuit. The set of parameters P2 consists (only) of parameters of the predetermined current (such as the induced DC bias).

Thus, the total energy of the superconducting quantum circuit does not depend on parameters of any device external to the superconducting quantum circuit or the predetermined current. Indeed, the Hamiltonian only depends of the set of parameters of the superconducting quantum circuit and/or the predetermined current, which may be predetermined according to quantum engineering specifications. Thus, the Hamiltonian does not depend on time, in particular not depending on any time-varying excitation, e.g., from a parametric pump.

In examples, the Hamiltonian may comprise linear terms. The linear terms describe the existence of modes hosted by elements of the circuit. In other words, each linear term describes the existence of a respective mode among the first and second modes hosted in the circuit.

The Hamiltonian may also comprise non-linear terms. The non-linear terms may describe the interaction between the first and second modes. The non-linear terms may also be called "mixing terms", in analogy with frequency mixing that occurs in classical non-linear microwave circuits. The non-linear terms may comprise a constant that may act as a prefactor. Said constant may describe the strength of the interaction between the first and second modes. The prefactor of the non-linear terms may be smaller or much smaller than the frequencies of the system. The non-linear terms may also be called resonant or non-resonant depending on how compatible they are with the preservation of energy.

The Hamiltonian may be expandable into a sum of terms. By "expandable into a sum of terms" it is meant that the operator (recalling that it represents the energy of the superconducting quantum circuit) admits a Taylor series approximation into a sum of terms. The total number of terms may be finite or possibly (theoretically) infinite, yet the sum of terms always remains finite, per the Taylor series approximation. The sum may comprise dominant terms and a series of subsidiary terms. By "dominant term" it is meant a term that has a significant impact on the dynamics of the system. For a term to be dominant, it must satisfy the two following conditions. First, the magnitude (e.g., in absolute terms or in an appropriate norm and with respect to the other terms in the Taylor series approximation) of the said term should have a significant contribution to the magnitude of non-linear part of the Hamiltonian. Second, the term should be resonant in the sense it is compatible with the preservation of energy. The series of subsidiary terms are the terms for which the magnitude of its sum is below the predetermined magnitude. This is all known per se from Taylor series approximations, and thus the subsidiary terms are omitted here. The Hamiltonian is expandable into a sum between at least a dominant term of the form ${ℏg}_{2 N} {a}^{2 N} {b}^{†} + {ℏg}_{2 N}^{∗} {a}^{† 2 N} b$ and a series of subsidiary terms (omitted here).

In the dominant term ${ℏg}_{2 N} {a}^{2 N} {b}^{†} + {ℏg}_{2 N}^{∗} {a}^{† 2 N} b$*, a* is the annihilation operator of the first mode, *b* is the annihilation operator of the second mode,. Conversely, *a*^{†}is the creation operator of the first mode, and *b*^{†} is the creation operator of the second mode. The dominant term ${ℏg}_{2 N} {a}^{2 N} {b}^{†} + {ℏg}_{2 N}^{∗} {a}^{† 2 N} b$ is a polynomial in *a, a*^{†}, *b, b*^{†}, that describes the resonant 2N-to-1 photon exchange. Thus, the dominant term including the term *ℏg_{2N}a^{2N}b*^{†} describes the annihilation of 2*N* photons of the first mode and the creation of one photon of the second mode. As the Hamiltonian is a Hermitian operator, the dominant term also includes a reciprocal term (also known as Hermitian conjugate, abbreviated as h.c.) ${ℏg}_{2 N}^{∗} {a}^{† 2 N} b$, where 2*N* photons of the first mode are created and one photon of the second mode is destroyed.

The scalar *g*_{2*N*} is a function of the set of parameters consisting of parameters of the circuit and/or parameters of the predetermined current. As the scalar *g*_{2*N*} is a prefactor of the dominant term, it denotes the strength of the interaction between the first and second modes (also called "intrinsic coupling strength"), namely the term *a^{2N}b*^{†} (respectively its Hermitian conjugate). In other words, *g*_{2*N*} describes the rate of the resonant 2N-to-1 photon exchange.

As the predetermined current is applied so as to induce the resonant 2N-to-1 photon exchange (that is, the predetermined current is tuned at the bias point), the rate of the resonant 2N-to-1 exchange term, that is, the constant *g*_{2*N*}, is non zero and the frequency matching condition ensures the term is resonant. In addition, the constant *g*_{2*N*} is large (in the sense of the Taylor series approximation) compared to the other non-linear terms (which are thus subsidiary and not described further).

Thus, as the predetermined current is applied so as to induce the resonant 2N-to-1 photon exchange, (that is, the frequency matching condition 2*Nωₐ = ω_{b}* is satisfied), the dominant term is a resonant term, i.e. it is compatible with energy preservation. For any N, the dominant term thus describes a non-linear interaction which is an odd power of the annihilation and creation operators.

Now, the Hamiltonian may include other dominant terms such as a Kerr term *ℏKₐa*^{†}*²a²*/2, *ℏK_{b}b*^{†2}*b*²/*2* or cross-Kerr terms ℏ*χ_{ab}a*^{†}*ab*^{†}*b.* Said non-linear terms may have a significant magnitude and are resonant by nature regardless of any frequency matching condition (this only occurs for even powers of the annihilation and creation operators). These Kerr and cross-Kerr terms may be considered as harmful for the desired engineered dynamics. However, the inventors have appreciated that the corresponding constant of the other non-linear terms(that is, the constants *Kₐ, K_{b}, χ_{ab},* among others) can be made small thanks to the choice of circuit parameters (illustrated in examples below) and in particular vanish near the optimal bias point. Thus, these terms are not further considered in the examples, and are only described for the sake of illustration.

The circuit may be configured to perform intrinsically a resonant 2-to-1 photon exchange between respectively the first mode and the second mode. In other words, N is equal to 1. In this case, the dominant term of the Hamiltonian may be a two-to-one interaction Hamiltonian ${ℏg}_{2} {a}^{2} {b}^{†} + {ℏg}_{2}^{∗} {a}^{† 2} b$*.* Alternatively, N may be higher than 1, e.g., N= 2. Coherent states of the first mode are eigenstates of the annihilation operator *a* acting on the first mode, e.g., for a given coherent state |α〉, it results that *a*|*α*〉*= α*|*α*〉, where *α* is a complex amplitude. In the paradigm of cat-qubits, the intrinsic 2-to-1 photon exchange stabilizes a quantum manifold of coherent states of the first mode. In the cat-cubit paradigm, cat qubit states may be defined from the coherent states; for example, the logical qubit state |0〉 may be defined as |*α*〉 and logical qubit state |1〉 may be defined as |-*α*〉. Both logical states belong to the quantum manifold of coherent states stabilized by the 2-to-1 photon exchange. Thanks to the stability of the quantum manifold achieved by the intrinsic 2-to-1 photon exchange, cat qubit states are naturally protected from errors such as bit-flip errors. Indeed, bit-flip errors may be suppressed autonomously and with exponential speed. This allows the implementation of quantum gates acting on the logical qubit states, such as CNOT, Toffoli and/or Hadamard gates, to perform fault tolerant computations.

The superconducting circuit has a symbolic representation, e.g., consisting of a set of interconnected dipoles.

By "symbolic representation", it is meant an arrangement of symbols and lines, the arrangement specifying a set of interconnected dipoles. The set of interconnected dipoles (also called components) forms a circuit structure (or topology) equivalent (in functioning) to the non-linear superconducting circuit.

In other words and as classical in the field of superconducting circuits, the non-linear superconducting circuit is configured so as to achieve the functioning defined by its symbolic representation, in other words the functioning of the theoretical set of interconnected dipoles shown by the symbolic representation. Yet in other words, while the circuit may be constructed using a patterned layer of superconducting material, it is to be understood that the circuit admits a symbolic representation by dipoles, for example, capacitors, inductors, and/or Josephson junctions. While the example dipoles describe discrete elements, it is to be understood that these elements correspond to the equivalent circuit of distributed elements in a specific frequency range (e.g. at low frequency), as known from the field.

The interconnections (of the set of interconnected dipoles of the symbolic representation) may be described via a network topology. In the network topology of this symbolic representation, each branch may represent a dipole of the circuit, a node may be a point of connection between two or more branches, and a loop may be a closed path of the circuit, that is, a path formed by starting at a given node, and returning to the starting node without passing through any node more than once. Each branch may comprise components (e.g., two or more) connected in parallel or in series.

For example, a pair of components comprising an inductor and a capacitor (that is, an LC resonator) may be implemented by distributed elements in the patterned layer of the superconducting material, such as:
- two neighboring plates forming a capacitor in parallel with a superconducting wire forming a inductor;
- a portion of superconducting transmission line which ends with 2 different boundary conditions (shorted to ground at one end and open at the other) forming a so-called *λ*/4 resonator. The transmission line being for example of the type coplanar waveguide or microstrip;
- a portion of superconducting transmission line which ends with 2 identical boundary conditions (open-open or short-short) forming a so-called *λ*/2 resonator, the transmission line being for example of the type coplanar waveguide or microstrip; or
- a 3D cavity carved in a block of superconducting material that resonate at given frequency that depends on its dimensions.

As known in the field, such distributed elements may have higher frequency modes which are irrelevant and unimportant for the dynamics described here. Hence, these distributed elements may be represented with the symbolic representation. This symbolic representation may be refined by adding elements such as series inductors with each wire connection or a parallel capacitor between any two nodes of the circuit or adding nodes and branches to take into account other modes of the distributed elements. Thus, the symbolic representation better describes the distributed elements but do not change the working principle of the circuit. Hence, as known in the art, the physical circuit (manufactured in the real world) and the symbolic representation are usually considered equivalent. Indeed, the refining dipoles of the symbolic representation only adjust the resonance frequencies or the zero-point fluctuation of the phase compared to the basic model. When designing the circuit, the final geometry may be fully and accurately simulated with a finite element solver which will readily give the frequencies of the modes, the dissipation originating from the loads and the zero point fluctuation of the phase across the Josephson junctions which are the only unknown to compute the resonant 2N-to-1 photon exchange rate in any configuration.

The symbolic representation of the circuit (e.g., the set of connected dipoles or components) comprises at least one superconducting loop, that is, a series of components (described by dipoles in the symbolic representation) connected together so as to form a cycle. The at least one loop includes one or more Josephson junctions. Each Josephson junction may consist of a thin insulating layer separating two superconducting leads, that allow Cooper pairs to tunnel through the insulating layer. Each Josephson junction may have a potential energy of the type *U*(*φ*) *= -E_{J}cos*(*φ*) where *E_{J}* is the Josephson energy of the junction and $φ = \frac{2 π Φ}{{Φ}_{0}}$ where Φ is the integral of the voltage across the junction and Φ₀ is the flux quantum. In examples, the Josephson energy may be tuned during fabrication by choosing the surface and thickness (hence the room temperature resistance) of the insulating barrier.

The Josephson junction is a non-linear inductor. Indeed, by comparing the potential energy of an inductive element *U*(*φ*) *= E_{L}φ*²/2 where *E_{L}* is the inductive energy, with the potential energy of the junction, at first order in *φ* the junction behaves as an inductor. When the predetermined current is applied to the circuit, the internal current flows through the junction (either from a direct connection or from the mutual inductance with the superconducting loop, the junction is embedded in), and this induces a phase-drop *φ_{DC}* across the junction. Thus, the application of the predetermined current modifies the potential energy of the Josephson junction as follows: $U \left(φ\right) = - {E}_{J} cos \left({φ}_{DC}+φ\right) = - {E}_{J} cos \left({φ}_{DC}\right) cos \left(φ\right) + {E}_{J} sin \left({φ}_{DC}\right) sin \left(φ\right) .$

The first term on the right side of the sum of the above equation is a cosine non-linearity describing a change of the effective Josephson energy of the junction *E_{J}* → *E_{J}*cos (*φ_{DC}*). Since the inductance of the Josephson junction is inversely proportional to the Josephson energy, the DC offset *φ_{DC}* enables tuning the inductance of the junction and hence the frequencies of the modes that participate in this junction. In the examples, the DC offset may be tuned to reach the frequency matching condition 2*Nωₐ = ω_{b}.* The second term describes a non-linearity corresponding to a sine non-linearity. The Taylor series expansion of the sine nonelinearity comprise terms of odd powers of *φ* providing odd wave mixing, and thus comprise the terms describing resonant 2N-to-1 photon exchange. In particular, the point at which the phase drop takes the value *φ_{DC} = π*/2, is where the junction's inductance becomes infinite (and thus the junction behaves as an open element). Consequently, the cosine non-linearity of the potential energy vanishes (that is, the potential energy is zero) and the sine non-linearity is at its maximum.

The other inductive element in the loop that are linear may keep the same inductance when a DC current flow through the loop or a DC phase-drop develops across the loop.

In examples, a Josephson junction of energy *E_{J}* embedded in the at least one loop of inductive energy *E_{L}*,may be described via the ratio $β = \frac{{E}_{J}}{{E}_{L}}$*.* When biased by the predetermined current, equivalently described by the effective magnetic flux *φₑₓₜ* that passes through the loop, an internal DC current arises in the superconducting loop and produces a phase drop *φ_{DC}* across the junction that depends only on *φₑₓₜ* and *β*. In examples, the phase drop may be computed numerically as the solution of the following equation: $φ + β sin \left(φ+{φ}_{ext}\right) = 0 , with 1 + β cos \left(φ+{φ}_{ext}\right) > 0 .$

The solution of the above equation may be called *f*(*φₑₓₜ, β*). For example, when a loop of inductance *E_{L}* comprises 2 junctions, each one having an energy *E_{J},* the phase drop across each junction is denoted by *φ_{DC} = f*(*φₑₓₜ*/2, *β*/2).

The Hamiltonian of the circuit may be determined in any manner. For example, the Hamiltonian may be determined by first determining the equivalent inductance of each junction when the predetermined supercurrent is applied to the circuit. This equivalent inductance (which depends on the DC phase-drop across the junction) is given by *L_{J}* = *φ₀*/*E_{J}*cos (*φ_{DC}*), where *φ*₀ is the reduced flux quantum Φ₀/2*π*. The frequencies of the mode may be computed algebraically or numerically, by replacing the junction in the circuit by its equivalent inductance, it may also be performed for more complex circuit layouts by performing microwave simulation with finite elements. These frequencies directly give out the linear part of the Hamiltonian. The modes frequencies can be computed along with the mode geometry which describes between any two points of the circuit what oscillating phase difference exist when the mode is excited. In order to compute the non-linearity of the system, the magnitude of the oscillating phase difference imposed across the Josephson junctions will be of particular interest. In the quantum regime, the phase difference across the junction may be written as: $φ = {φ}_{DC} + {φ}_{a} \left(a+{a}^{†}\right) + {φ}_{b} \left(b+{b}^{†}\right) + ⋯$ where *φ_{DC}* is the DC phase offset computed earlier, *φ*ₐ and *φ_{b}* are the zero-point fluctuation of the phase across the junction which is directly to the geometry of the mode up to a normalization. The phase difference may include other terms in "..." (e.g. associated with other modes), these terms are omitted since these are unimportant for the invention.

The non-linear terms of the Hamiltonian may be computed by performing a Taylor approximation on the potential energy of the junction, -*E_{J}*cos (*φ*) and by summing the contribution of each junction of the circuit. In order to fully describe the circuit, it is just required to find out the DC phase drop across the junction, the frequencies of the modes and the zero-point fluctuations of the phase across the junction associated with each mode of the system.

In examples, as the circuit hosts the first and second modes at respective frequencies *ωₐ*/2*π* and *ω_{b}*/2*π*, the linear part of the Hamiltonian may be written as: $H = {ℏω}_{a} {a}^{†} a + {ℏω}_{b} {b}^{†} b ,$ where ℏ is the reduced Plank constant.

Given that at least one term of the interaction provided by the Josephson junction is of the form; ${H}_{J} = {E}_{J} sin \left({φ}_{DC}\right) sin \left({φ}_{a}\left(a+{a}^{†}\right)+{φ}_{b}\left(b+{b}^{†}\right)\right) ,$ where *φ_{DC}* is the DC phase-drop across the junction induced by the predetermined current and *φₐ* and *φ_{b}* are the zero-point fluctuation of the phase across the junction associated with the first mode and second mode respectively. The Hamiltonian may thus be expanded in a Taylor series (e.g., in any desired with respect to the Taylor series expansion) so as to obtain the resonant 2N-to-1 photon exchange Hamiltonian ${H}_{NL} = {ℏg}_{2 N} {a}^{2 N} {b}^{†} + h . c .$ where ${ℏg}_{2 N} = {E}_{J} \frac{{φ}_{a}^{2 N} {φ}_{b}}{2 N !}$ is the resonant 2N-to-1 photon exchange rate that is resonant provided 2*Nωₐ = ω_{b}.* Thus, the resonant 2N-to-1 photon exchange only depends on the parameters of the circuit and of the predetermined current, such as said parameters.

In contrast, and as mentioned previously, prior art realisations involve the use of a parametric pump to perform the 2-to-1 photon exchange. In these prior art realisations, the two-to-one photon interaction Hamiltonian is of the form $\frac{{H}_{2}}{ℏ} = {g}_{2} \left(t\right) {a}^{2} {b}^{†} + h . c .$ Here, the coupling term *g*₂(*t*) is modulated via the parametric pump, where the pump injects an external time-varying parameter having a frequency *ωₚ* = 2*ωₐ* - *ω_{b}.* The parametric pump is used in the prior art to render the non-linear interaction resonant but has detrimental effects.

Examples and illustrations of the circuit and device are now discussed with reference to the figures.

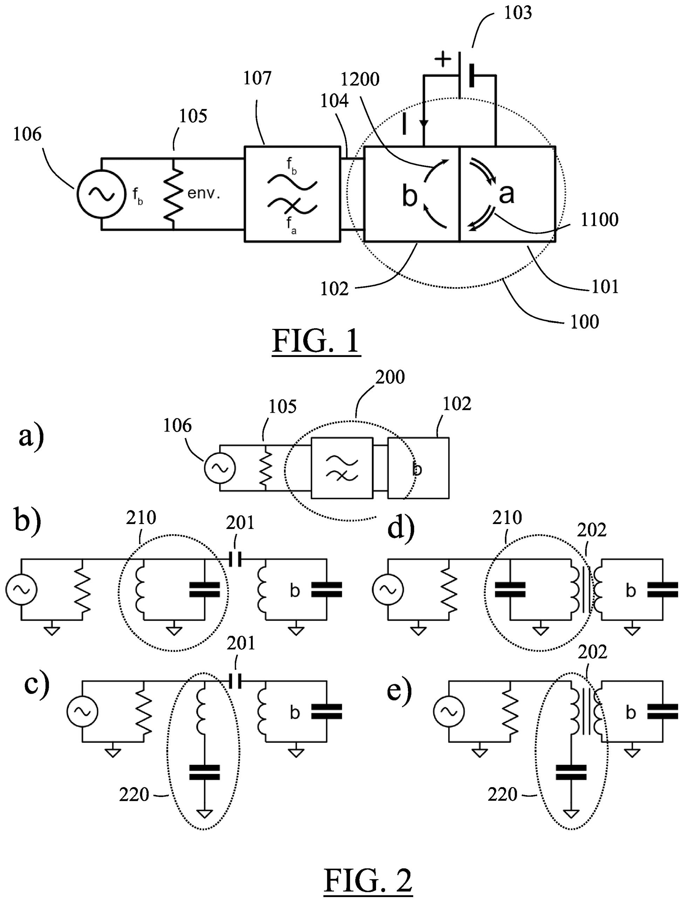

FIG. 1 shows an example of the device.

For the sake of illustration, N=1 hereunder in the discussion, but the discussion also applies to the case of arbitrary N. The device incorporates the non-linear superconducting circuit 100, which performs intrinsically the 2-to-1 photon exchange (symbolized by a back and forth single arrow 1200 and the double arrows 1100) between the first mode *a* 101 and the second mode *b* 102. The current source 103 is connected via wires to the non-linear superconducting circuit. In other words, the current source 103 is directly connected to the circuit so that the predetermined current flows through at least a subset of elements of the non-linear superconducting circuit 100. The current source 103 is configured to apply the predetermined current to the circuit 100. The current source 103 both enables a 3-wave mixing interaction and tunes the frequency matching condition as *2fₐ = f_{b}.* The components of the circuit hosting the second mode 102 are coupled via a coupler 104 to a load 105. This coupling makes the second mode dissipative. The device also incorporates a microwave source 106 at frequency *f_{b}* used to drive the circuit 100. The device incorporates a microwave filter 107 configured as a band pass filter with a frequency *f_{b}.* Alternatively, the filter 107 may be configured as a band stop filter at a frequency *fₐ*, and may be placed in between the environment and the two modes to isolate the first mode and thus prevent the first mode from suffering of additional losses coming from unwanted coupling to the load 105.

FIG. 2 shows examples of the coupling of the second mode of the superconducting circuit to the load, and filters that may be integrated to the device so as to only allow the coupling of the second mode to the load.

FIG. 2a shows a schematic describing the coupling 200 to the device via the coupler 104 and the filter 107, so as to couple the second mode 102 of the circuit 100 of FIG. 1 to the load, and to ensure driving the circuit 100 with a microwave source 106 at frequency *f_{b}*, while only allowing losses of the second mode (modeled as a resistor 105) at the second resonant frequency *f_{b}* and not allowing losses of the first mode (at the first resonance frequency *fₐ*). FIG. 2 admits at least two possibilities for the coupling 200: a band pass filter (also shown in FIG.s 2b and 2d) at frequency *f_{b}* or band stop filter (also shown in FIG.s 2c and 2e) at frequency *fₐ*. Yet alternatively, when the circuit is manufactured in a 3D architecture, another possible solution is the use of a waveguide high-pass filter to couple to the second mode to the load, thanks to the high frequency selectivity.

FIG.s 2b to 2e show the different possibilities for the coupling 200.

FIG. 2b shows a band pass filter 210 at frequency *f_{b}* capacitively coupled (201) to the input port. The band pass filter (which is an LC oscillator) 210 is configured to resonate at frequency $2 {πf}_{b} = \sqrt{1 / LC}$, its impedance $Z = \sqrt{L / C}$ tunes the width of the band pass.

FIG. 2c shows a band stop filter 220 at frequency *fₐ* capacitively coupled 201 to the input port. The band stop filter 220 (which is an LC stub) is configured to resonate at frequency $2 {πf}_{a} = \sqrt{1 / LC}$, its impedance $Z = \sqrt{L / C}$ tunes the width of the band stop.

FIG. 2d shows a band pass filter 210 at frequency *f_{b}* inductively coupled 202 to the input port. The band pass filter 210 (which is an LC oscillator) is configured to resonate at frequency $2 {πf}_{b} = \sqrt{1 / LC}$, its impedance $Z = \sqrt{L / C}$ tunes the width of the band pass. This configuration is convenient because the microwave radiation (e.g., RF) input port of the device can also be used to input the current bias.

FIG. 2e shows a band stop filter 220 at frequency *fₐ* inductively coupled (202) to the input port. The band stop filter (which is an LC stub) is configured to resonate at frequency $2 {πf}_{a} = \sqrt{1 / LC}$*,* its impedance $Z = \sqrt{L / C}$ tunes the width of the band stop.

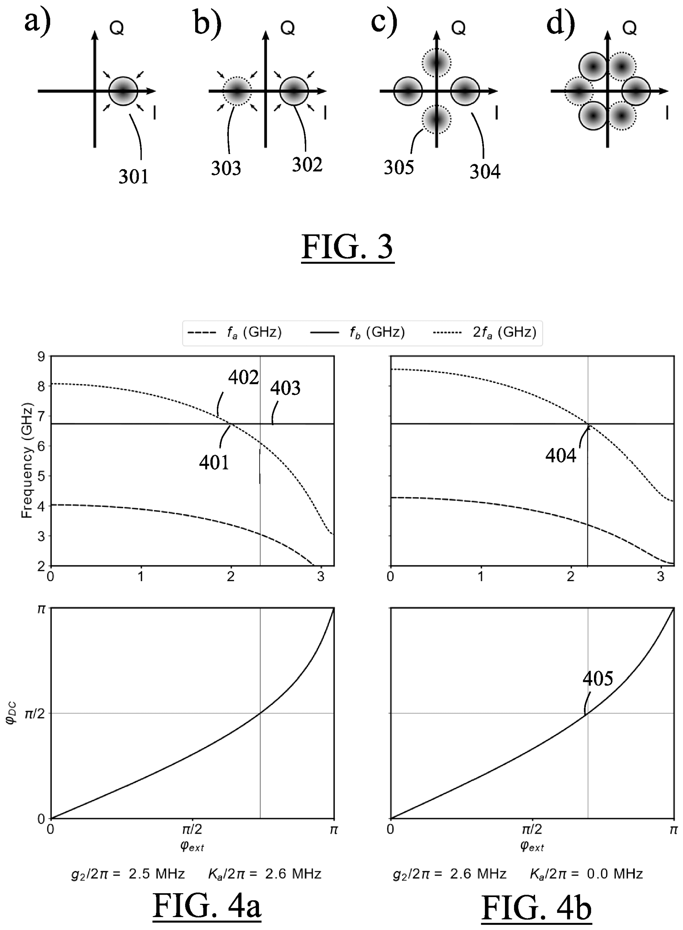

FIG. 3 illustrates examples of stabilization a quantum manifold of coherent states of the first mode, achieved by the resonant 2N-to-1 photon exchange.

FIG. 3a illustrates a linear scheme comprising a single photon drive (microwave tone at the mode frequency) characterized by an amplitude *ε*₁ and single photon dissipation with rate *κ*₁. After a timescale 1/*κ*₁, the mode state converges to a single coherent state 301 of amplitude *α* = 2*ε*₁/*κ*₁. This is the stable steady state of the dynamics. However, this steady state is unique and one cannot encode information into it. The state is represented as a blurry point in the quadrature space of the mode due to the uncertainty principle of quantum mechanics.

FIG. 3b illustrates a first mode undergoing a two-photon drive with strength *ε*₂ and two-photon dissipation with rate *κ*₂ that has 2 stable steady states (302, 303) of amplitude $α = \sqrt{2 {ε}_{2} / {κ}_{2}}$ and with opposite phase. Since there are have two possible states, one can encode information, the state |0) 302 is circled with a solid line and the state |1〉 303 with a dotted line. This encoding is robust against bit-flip errors that flip the system between state |0〉 and state |1〉 thanks to the stable nature of the dynamics that converges to the two states. The encoding does not correct the other error channel (that is, does not correct phase-flip errors) however an additional error correcting scheme may be added to treat this separately. This stabilization is made possible by coupling to an extra mode and by engineering a 2-to-1 photon exchange between the first mode and the second mode.

FIG. 3c Illustrates the case N=2, which uses a 4-photon drive and 4-photon dissipation to stabilize 4 states in the phase space. In this 4 dimensional manifold, one can encode a state |0〉 in one superposition of 2 coherent states 304 (shown in solid lines) and a state |1〉 in another superposition of 2 coherent states 305 (shown in dashed lines). There remains 2 degrees of freedom in the 4 dimensional manifold which can serve as an error manifold used to perform first order quantum error correction This stabilization is made possible by coupling to an extra mode and by engineering a 4-to-1 photon exchange between the first mode and the second mode.

FIG. 3d illustrates the increase of the dimension of the stabilized manifold. The increase in dimension allows for a higher order error correction, compared to lower values of N. With 6 photon drive and 6 photon dissipation (that is, N=3), one can stabilize a 6 dimensional manifold of coherent states that can perform second order quantum error correction. This stabilization is made possible by coupling to an extra mode and by engineering a 6-to-1 photon exchange between the first mode and the second mode.

FIG. 4 illustrates examples of how to determine the intensity of the current to be applied to the circuit.

FIG. 4a, shows the tuning of the predetermined current to be applied to the superconducting circuit. For a given N, the bias point is the point at which the resonant frequencies of the first and second modes fulfils the matching condition 2*Nωₐ = ω_{b}.* In other words, the equality may have a margin of error of the order of magnitude of a constant *g*_{2*N*} (which describes the rate of the resonant 2N-to-1 photon exchange). The bias point may be reached by varying the current of the circuit, and it corresponds to the point 401 that is experimentally determined by the anti-crossing between a virtual 2*Nωₐ* frequency line 402 and the *ω_{b}* spectroscopic frequency line 403. The parameters of the elements of the circuit may be chosen in a range where the frequency of the two modes are close to the frequency matching condition.

For some circuits, there exists an optimal choice of parameters of the elements of the circuit. Thus, the bias point is an optimal bias point. At this optimal bias point spurious even terms such as Kerr and cross-Kerr terms are also cancelled.

FIG. 4b shows that the optimal bias point 404 may coincide with the point 405 where the DC phase drop across the junction is *π*/2. To reach this optimal bias point, parameters of the circuit may be well targeted at fabrication and a separate tuning knob is added. This extra tuning nob (which is realized by incorporating in the second mode a SQUID, two junctions in parallel, biased with an external current in order to control its frequency independently) is used as an extra degree of freedom to reach both the frequency matching condition and the vanishing Kerr condition.

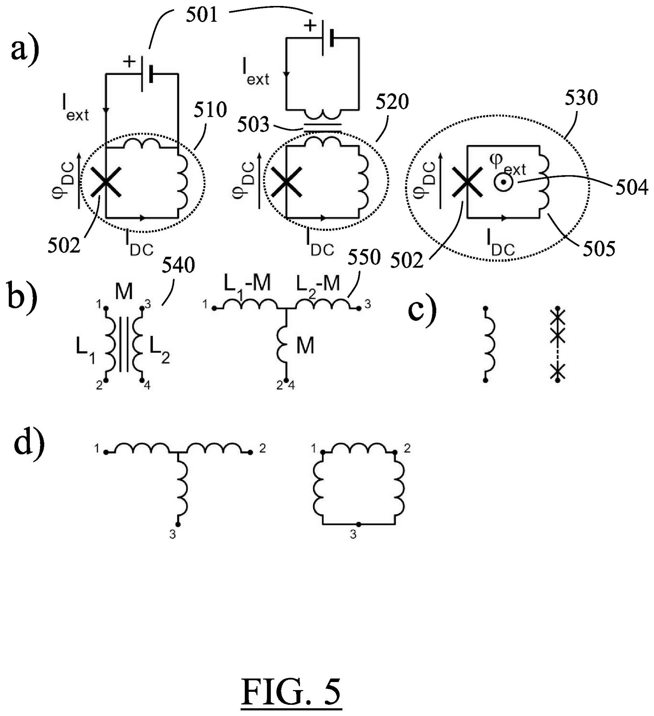

FIG. 5 shows several examples of circuit symbolic representations alternatively used throughout this description.

FIG. 5a shows two example implementations of the current bias: a direct bias via galvanic connection and a mutual inductance bias symbolized by transformer 503 which generates a magnetic field to induce an internal current to the circuit. The first circuit (on the left hand of FIG. 5a) shows a current source 501 galvanically coupled to the superconducting loop. The examples show that at least one terminal of the current source is directly connected to the superconducting loop 510, which is isolated from the rest of the circuit for convenience. This is however a matter of implementation. The current source may be connected in any manner so as to apply the predetermined current, as shown below. When applying the predetermined current *Iₑₓₜ,* there is a phase-drop *φ_{DC}* flows across the junction 502. This is because a portion of the internal current, *I_{DC},* passes through the junction 502. The second circuit (in the right side of the first circuit) shows a current source inductively coupled to the superconducting loop via mutual inductance 503. This is diagrammatically shown as a transformer (503). The current source generates a magnetic field which in turns generates a current in the superconducting loop. This current is associated with a phase-drop across the junction.

Thus, the current source may be implemented in any manner so as to achieve a phase drop across the junction. FIG. 5a exemplifies this in the circuit 530 that equivalently summarizes the two previous circuits of FIG. 5a. Upon application of the predetermined current (by any one of the standard current source or the transformer), the flux *φₑₓₜ* 504 represents the effective magnetic field that biases the loop induced by the predetermined current applied to the circuit. The flux may also be called external flux *φₑₓₜ* when integrated on the surface of the loop in the following. The inductance 505 represents the total self-inductance of the superconducting loop in which is embedded the junction 502. This final notation is also used when the circuit is placed in a global magnetic field which may be produced by a magnetic coil outside the plane of the circuit the axis of which being perpendicular to the plane of the circuit. The external flux can be expressed as an angle *φₑₓₜ =* 2*π*Φ*ₑₓₜ*/Φ₀ where Φ₀ is the flux quantum. For this application, it may be assumed that the system is periodic in *φₑₓₜ* with period 2*π* and symmetric with respect to *φₑₓₜ* = 0. Hence, analysis may be restricted to the interval *φₑₓₜ* ∈ [0, *π*].

FIG. 5b shows an alternative description of the transformer (as the current source). The transformer 550 may be two circuit branches that are not galvanically connected (that is, not directly in contact) and which share a mutual inductance due to their proximity. Alternatively, the transformer 550 may be portion of the circuit where two loops galvanically share a common conductor. The transformer 550 can be effectively implemented in practice.

FIG. 5c shows replacing the inductances with arrays of junctions in series. Unless specified otherwise, this array can comprise down to a single junction.

FIG. 5d shows a Y-Δ transform for inductors can be used to change the topology of the circuit without changing its behaviour producing an alternative circuit that simplifies the analysis, however following the same principles of the other embodiments.

The circuit may be configured to perform the resonant 2N-to-1 photon exchange when the predetermined current is applied so as to induce a phase difference across the one or more Josephson junctions. Examples below illustrate how the energy of the Josephson junction (and more generally of a non-linear inductive device) may be engineered so as to perform the resonant 2N-to-1 photon exchange. The presence of at least one loop including one or more Josephson junctions facilitates the intrinsic resonance of the circuit. Indeed, the energy of the Josephson junction may depend on the parameters of the components hosting the first and second modes, and the predetermined current inducing an internal current flowing through the at least one loop. Indeed, one or more Josephson junctions comprised in the loop provide mixing capabilities which enable the resonant 2N-to-1 photon exchange. That is, the energy of the one or more Josephson junctions describe the interaction of the first and second mode created by the resonant 2N-to-1 photon exchange when the predetermined current is applied through at least two nodes of the circuit.

Examples hereunder assume that the circuit is operated at the optimal bias point per the above principles. This is provided for the sake of readability of the mathematical expressions provided below. However, it is to be understood that the examples below also apply to the case of a non-optimal bias point.

FIG.s 6a to 6e shows examples of the circuit 600, where the symbolic representation of the circuit comprises at least one loop that includes one or more Josephson junctions. The circuit 600 of this example is configured to perform the resonant 2N-to-1 photon exchange when the predetermined current is applied so as to induce a phase difference across the one or more Josephson junctions. Circuit 600 of this example is provided without an input current source. However, it is to be understood that the current source may be implemented in any manner so as to induce a current bias into the at least one loop. This may be achieved by a standard current source (connected galvanically in any manner to the circuit) or a transformer which generates a magnetic field to induce an internal current to the circuit 600. Examples below show a particularly efficient implementation of the current source in the circuit 600.

In the circuit 600, the at least one loop 610 includes a first Josephson junction 601 arranged in parallel with a first inductive element 602 and a first capacitive element 603. An inductive element (such as the first inductive element 602) may be a dipole (or ensemble of dipoles) designed for adding inductance to the circuit. For example the inductive element may be a single inductor (that is, a single superconducting strip with a given inductance) or several inductors arranged in series. In the case of several inductors arranged in series, the total inductance is the sum of the respective inductances of each inductor. Alternatively and/or additionally, the inductive element 602 may also comprise an array of Josephson junctions that should contain at least two junctions. A capacitive element (such as the first capacitive element 603) may be a single capacitor or a several (that is, more than one) capacitors arranged in parallel. The loop comprises respective first and second extremum nodes. Each respective extremum node is thus a common node connecting a respective node of the first Josephson junction 601 with the first inductive element 602 and the first capacitive element 603.

Moreover, the Josephson junction 601 has a Josephson energy *E_{J}*, the inductor 602 has an energy denoted as *E_{L}* and the capacitor 603 has an energy denoted as *E_{C}.*

The circuit may also comprise a second inductive element 605 and a second capacitive element 604 arranged in parallel to form a resonator 620. The arrangement may comprise respective first and second extremum nodes, each connecting the second inductive element 605 and the second capacitive element 604. The inductive element 605 may have an energy denoted as *E_{Lr}* and the capacitive element 604 may have an energy denoted as *E_{Cr}.* The circuit may also comprise a coupling capacitive element 606 or inductive element 607. The parallel LC resonator 620 is linearly coupled to the non-linear resonator formed by the Josephson junction 601, the inductive element 602 and the capacitive element 603 in parallel. As said above, the circuit 600 is a symbolic representation of the superconducting circuit. Thus, elements of the circuit, such as the resonator 620 may be fabricated in any manner as known in the art; for example, it may be a portion of a transmission line or a 3D cavity. The resonator maybe as well a mechanical resonator that couple capacitively 606 via a piezo-electric material.

The respective first extremum node of the loop 610 may be connected to the respective first extremum node of the second inductive element 605 and the second capacitive element 604 may be arranged in parallel via the coupling capacitive element 606 or inductive element 607. The respective second extremum node of the loop 610 and the respective second extremum node of the second inductive element 605 and the second capacitive element 604 arranged in parallel may be connected to a common ground.

When coupled via the coupling element (606, 607), the resonators hybridize slightly provided their frequencies are different and the coupling element is small (small capacitance, large inductance) forming 2 modes. A linear mode 608 that may be mostly hosted (or localized) on the linear resonator 620. A non-linear mode 609 that is mostly hosted (or localized) on the parallel arrangement of the loop 610 and first capacitive element 603. The circuit is thus arranged so as to perform intrinsically the resonant 2N-to-1 photon exchange.

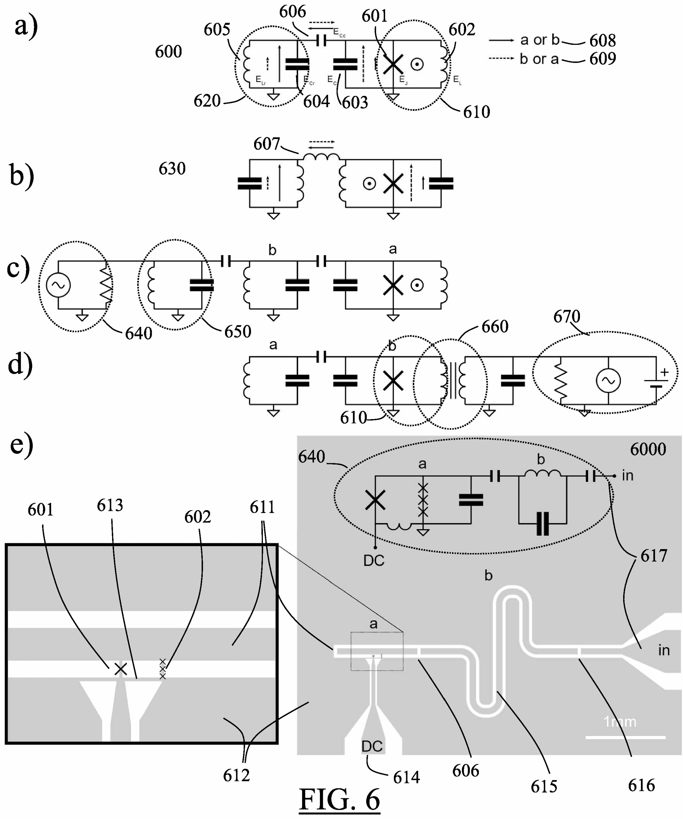

FIG. 6b shows another circuit 630 which is a variation of circuit 600. The difference is the replacement of the coupling capacitor with an inductor 607. This is just an alternative implementation using the same principles as above.

FIG.s 6c and 6d shows examples of the device incorporating the circuit 600. In addition, the examples illustrates how the modes may be chosen according to experimental constraints. In FIG. 6c, the non-linear mode can be the first mode and the linear mode can be the second mode . FIG. 6d shows an example in which the first mode is a linear mode and the second mode is a non-linear mode.

In addition, FIG. 6c shows a microwave source 640 driving the circuit, coupled to a resistive load for dissipation. In addition, an LC resonator 650 serves as a band pass filter. The resonant frequency of the LC resonator is tuned at the resonant frequency of the second mode so ass to function as a band pass filter.

FIG. 6d shows another example of the device incorporating the circuit 600. Here, a dc current source is coupled with the microwave source and a resistive load 670. The current source is coupled to the circuit via a transformer 660, which induces a current to the loop 610.

The alternatives of FIG. 6b to 6d follow the same principles as the circuit of FIG. 6a and the device. In particular, the choice of which mode (of the first and second modes) may be linear depends on the trade-off of a given experimental set-up.

FIG. 6e shows an example of the implementation of the symbolic representation of the circuit 600 in a planar superconducting pattern. The superconducting circuit is manufactured in a coplanar waveguide geometry (CPW). The background 6000 of the planar superconducting pattern corresponds to superconducting metal remaining on the dielectric substrate after fabrication. Josephson junctions are represented as black crosses. The non-linear mode is hosted in a superconducting island 611 which has a capacitance to ground 612 and is connected to ground via a single junction 601 and a three-junction array 602 that acts as a compact inductive element. The superconducting loop that is formed is flux biased galvanically with a DC current line that shares part of the inductance to ground 613 with the resonator. The wires that bring the DC current are connected to the DC port 614 and to ground. The DC port 614 is connected to the current source (which may be a current source at ambient temperature) via superconducting and nonsuperconducting wires. This lumped resonator is capacitively coupled 606 to a coplanar waveguide A/2 resonator 615 that acts as a second mode. This coplanar waveguide A/2 resonator has multiple resonances, each of them can be modelled by a LC resonator just as 620. In turns this second mode is coupled capacitively 616 to the external environment that connect to the circuit via the RF input port 617. In this design, the filter is not shown. The resistive load, is typically the 50 Ω transmission line that terminates in the 50 Ω input of a microwave generator. The inset diagram 640 is a zoom on the junction layout of the planar superconducting pattern.

Referring again to the circuit 600, it is shown the computation of the dominant terms of its Hamiltonian rate describing the resonant 2N-to-1 photon exchange. Again, for the sake of illustration, it is assumed that the parameters of the circuit are designed such that the bias point is an optimal bias point. This means that the frequency matching conditions coincides with the point where *φ_{DC}* = *π*/2*.* In that case, the inductive energy of the loop (610) is given solely by the inductance and hence the frequency of the non-linear resonator is given by ${ω}_{nl} = \sqrt{8 {E}_{C} {E}_{L}}$. The frequency of the linear resonator is given by ${ω}_{l} = \sqrt{8 {E}_{Cr} {E}_{Lr}}$. In some configurations, the frequencies may be chosen as *ωₗ* = *ω_{b}* = 2*Nωₐ =* 2*Nωₙₗ* (e.g. FIG. 6c) or *ωₗ* = *ωₐ = ω_{b}*/2*N = ωₙₗ*/2*N* (e.g. FIG. 6d). First, as exemplified in FIG.s 6c, computations are performed assuming the non-linear mode is the first mode *a* and the linear mode is the second mode *b*. Regardless on how the linear coupling is made in between the two resonators, it may be summarized by defining a coupling strength *g.* The detuning between the two modes may be defined as Δ *= ω_{b} - ωₐ = (2N -* 1)*ωₐ* at the frequency matching condition. Since in practice *g* ≪ Δ, the detuning is in the so-called dispersive limit which enables to simplify the computation of the non-linear Hamiltonian. This linear coupling will affect slightly the frequencies of the two modes. A full diagonalization of the two modes system allows to adjust the values of *E_{C}, E_{L}, E_{Cr}, E_{Lr}* to get the targeted frequencies. At the optimal bias point and in the limit *g* « Δ, the interaction provided by the junction may be expressed as: ${H}_{J} = {E}_{J} sin \left({φ}_{a}\left(a+{a}^{†}+ϵb+ϵ{b}^{†}\right)\right) ,$ where ${φ}_{a} = {\left(\frac{2 {E}_{C}}{{E}_{L}}\right)}^{1 / 4}$ is the zero point fluctuation of the phase across the Josephson junction associated with mode *a,* $ϵ = \frac{g}{Δ} \frac{{ω}_{b}}{{ω}_{a} + {ω}_{b}}$ describes the linear coupling and *εφₐ* is the zero point fluctuation of the phase across the Josephson junction associated with mode *b*. By expanding this Hamiltonian at the desired order one can get the resonant 2N-to-1 photon exchange Hamiltonian ${H}_{NL} = {ℏg}_{2 N} {a}^{2 N} {b}^{†} + h . c .$ where ${ℏg}_{2 N} = {E}_{J} ϵ \frac{{φ}_{a}^{2 N + 1}}{2 N !}$.

If the converse choice is made, as exemplified in FIG.s 6d (the linear mode is the first mode *a* and the non-linear mode is the second mode *b*), the interaction provided by the junction writes ${H}_{J} = {E}_{J} sin \left({φ}_{b}\left(b+{b}^{†}+ϵa+ϵ{a}^{†}\right)\right) ,$ where ${φ}_{b} = {\left(\frac{2 {E}_{C}}{{E}_{L}}\right)}^{1 / 4}$ is the zero point fluctuation of the phase across the Josephson junction associated with mode *b,* $ϵ = \frac{g}{Δ} \frac{{ω}_{a}}{{ω}_{a} + {ω}_{b}}$ characterizes the linear coupling. By expanding this Hamiltonian as a Taylor series allows to obtain the resonant 2N-to-1 photon exchange Hamiltonian ${H}_{NL} = {ℏg}_{2 N} {a}^{2 N} {b}^{†} + h . c .$ where ${ℏg}_{2 N} = {E}_{J} {ϵ}^{2 N} \frac{{φ}_{b}^{2 N + 1}}{2 N !}$.

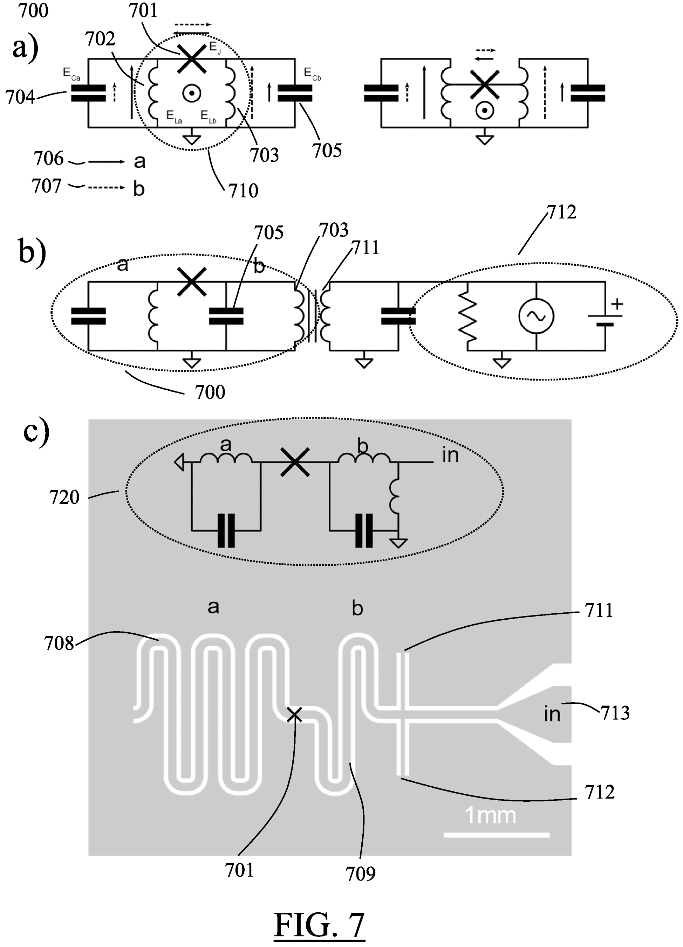

FIG.7 shows another example of the circuit, where the symbolic representation of the circuit comprises at least one loop that includes one or more Josephson junctions. The circuit 700 according to this example is also configured to perform the resonant 2N-to-1 photon exchange when the predetermined current is applied so as to induce a phase difference across the one or more Josephson junctions. Circuit 700 according to this example is in particular configured to perform intrinsically the resonant 2N-to-1 photon exchange between respectively the first mode and the second mode in such a way that the two modes are hosted concurrently in the loop.

In the circuit 700, the at least one loop 710 may include a first inductive element 702, a central Josephson junction element 701, and a second inductive element 703 arranged in series. Each of the first or second inductive element (702, 703) may be an inductance, a single Josephson junction or an array of Josephson junctions. The central Josephson junction 701 may thus be arranged between the first and second inductive element as a loop in series. The arrangement in series may comprise a first inner node connecting a pole of the first inductive element 702 with a pole of the Josephson junction 701. The arrangement in series may also comprise a second inner node connecting a pole of the second inductive element 703 with another pole of the Josephson junction 701. The arrangement in series may also comprise a closed-loop node connecting another pole of the first inductive element 702 with another pole of the second inductive element 703.

Said at least one loop may be connected to a common ground via the closed-loop node. The circuit may also comprise a first capacitor 704 and a second capacitor 705. The first capacitor 704 may be connected in parallel with the first Josephson junction 702 between the common ground and the first inner node of the loop. The second capacitor 705 may be connected in parallel with the second Josephson junction 702 between the common ground and the second inner node of the loop. The superconducting quantum circuit 700 is thus configured to perform intrinsically the resonant 2N-to-1 photon exchange between respectively the first mode and the second mode when a predetermined current is applied.

As said before, the circuit 700 is thus configured to perform intrinsically the resonant 2N-to-1 photon exchange between respectively the first mode and the second mode in such a way that the two modes are hosted concurrently in the loop. This maximizes there participation in the central junction and hence increases the strength of the resonant 2N-to-1 photon exchange. The circuit on right hand side of FIG. 7a shows how one can choose the participation of the central junction to tune the non-linearity of the circuit and hence the strength of the resonant 2N-to-1 photon exchange. This is done by connecting the junction at the desired level along the inductive part of the modes in order to pick-up only a portion of the zero-point fluctuations of the phases.

It is again assumed, for the sake of illustration, that the circuit is designed to be biased at its optimal bias point. To simplify the derivation of the Hamiltonian of the circuit 700 of this example, it is assumed that the intrinsic capacitance of the junction is zero. In practice, a full diagonalization of the system can take into account a finite capacitance. In this limit, the LC-resonators, a first LC resonator formed by the first inductive element 702 and the first capacitor 704, and a second LC resonator formed by the second inductive element 703 and the second capacitor 705 each host a respective mode of the circuit. Hence, the frequency of the first mode (left resonator for instance) is given by $\sqrt{8 {E}_{Ca} {E}_{La}}$ and the frequency of the second mode (right resonator for instance) by $\sqrt{8 {E}_{Cb} {E}_{Lb}}$*,* these components being adjusted to reach the frequency matching condition 2*Nωₐ = ω_{b}.* Then, since *φ_{DC}* is assumed to be *π*/2 the junction Hamiltonian writes: ${H}_{J} = {E}_{J} sin \left({φ}_{a}\left(a+{a}^{†}\right)+{φ}_{b}\left(b+{b}^{†}\right)\right)$ **where** ${φ}_{a} = {\left(\frac{2 {E}_{Ca}}{{E}_{La}}\right)}^{1 / 4}$ and ${φ}_{b} = {\left(\frac{2 {E}_{Cb}}{{E}_{Lb}}\right)}^{1 / 4}$. By expanding this Hamiltonian at the desired order one can get the resonant 2N-to-1 photon exchange Hamiltonian: ${H}_{NL} = {ℏg}_{2 N} {a}^{2 N} {b}^{†} + h . c .$ where ${ℏg}_{2 N} = {E}_{J} \frac{{φ}_{a}^{2 N} {φ}_{b}}{2 N !}$*.*

FIG. 7b shows another example of a symbolic representation of the device comprising the circuit 700. The circuit 700 is the same as in FIG. 7a, with a simple rearrangement of the capacitor 705 and the inductor 703 for the sake of readability of the symbolic representation. Thus, in the circuit 700 comprised in the device, the first mode is coupled to the second mode via the Josephson junction. Both the first and second LC resonators of the circuit 700 are shorted to the superconducting ground in the other end (not coupled to the Josephson junction) enabling the formation of superconducting loop that can be biased to reach the optimal bias point. The second LC resonator is inductively coupled (via a transformer 711) to another resonator that acts as bandpass filter between the system and a tailored environment 712. The environment 712 comprises a load, a microwave source and a DC current source. In the same way as before, the same input port of the device may be conveniently used to bring DC current and microwave radiation to the circuit.

FIG. 7c shows an example of the fabrication of the circuit 700 as a planar superconducting pattern. The presented superconducting circuit is configured in a coplanar waveguide geometry (CPW) where the grey part represents the superconducting metal left on the dielectric substrate. The cross in black represents the Josephson junction. This circuit consist of two λ/4 resonators, the left one (708, first mode) is simply connected to ground and the right one (709, second mode) is doubly connected to ground (711, 712) to enable the preservation of symmetry while coupling to the external environment that is connected via the input line 713. The junction 701 is placed in between the two resonators at an antinode of electric field to maximize the non-linearity of the system. Alternatively, one may connect the junction at any point along each resonator transmission line, to adjust the level of non-linearity (shown in the right circuit of FIG. 7a). The input line 713 shares an inductance to ground with the second mode. This enables inductive coupling of the second mode to the environment and DC current bias (by a current source placed in ambient temperature) to the input line 713. Thus, the current source may be connected to standard wires at room temperature, and progressively connected to superconducting wires which are in turn connected to the input line 713, so as to transfer the predetermined current (not shown here). In order to preserve the symmetries of the system, this circuit has two superconducting loops in parallel which effectively boil down to one as shown in the electrical diagram 720.

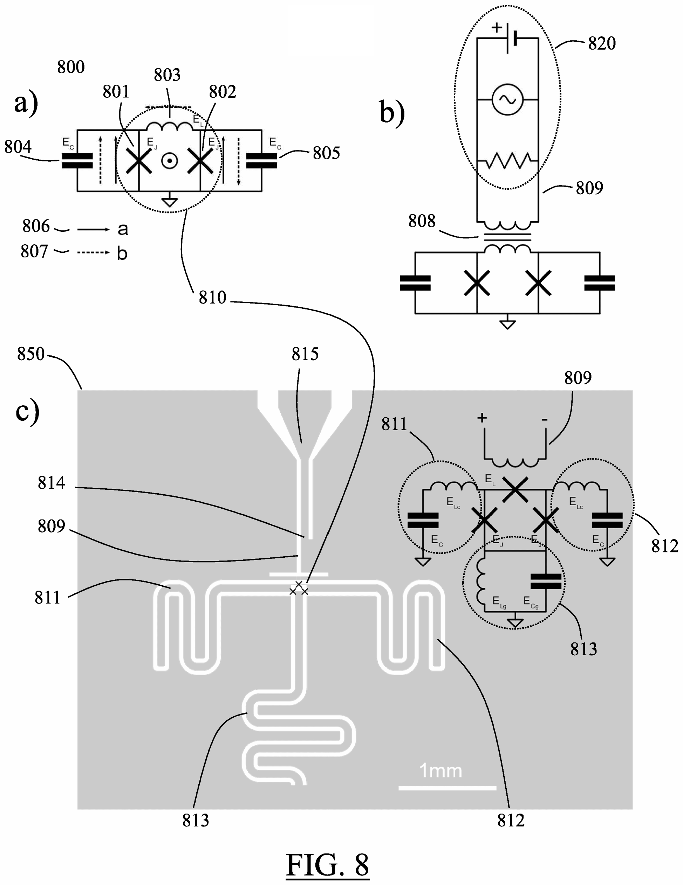

FIG. 8 shows another example of the circuit, where the symbolic representation of the circuit comprises at least one loop that includes one or more Josephson junctions. The circuit 800 according to this example is also configured to perform the resonant 2N-to-1 photon exchange when the predetermined current is applied so as to induce a phase difference across the one or more Josephson junctions. Circuit 800 according to this example is in particular configured to discriminate symmetrically the first and second mode. The high symmetry of the circuit achieves an improved quality of the resonant 2N-to-1 photon exchange.

With reference to FIG. 8 another example of a circuit 800 having at least one loop 810 is now discussed. In the circuit 800, the at least one loop 810 may include a first Josephson junction 801, a central inductive element 803, and a second Josephson junction 802 arranged in series. The central inductive element 803 may be an inductance, a single Josephson junction or an array of Josephson junctions. The central inductive element 803 may thus be arranged between the first and second Josephson junctions as a loop in series. The arrangement in series may comprise a first inner node connecting a pole of the first Josephson junction 801 with a pole of the inductive element 803. The arrangement in series may also comprise a second inner node connecting a pole of the second Josephson junction 802 with another pole of the inductive element 803. The arrangement in series may also comprise a closed-loop node connecting another pole of the first Josephson junction 801 with another pole of the second Josephson junction 802.

Said at least one loop may be connected to a common ground via the closed-loop node. The circuit may also comprise a first capacitor 804 and a second capacitor 805. The first capacitor 804 may be connected in parallel with the first Josephson junction 801 between the common ground and the first inner node of the loop. The second capacitor 805 may be connected in parallel with the second Josephson junction 803 between the common ground and the second inner node of the loop.

The superconducting quantum circuit 800 is thus configured to perform intrinsically the resonant 2N-to-1 photon exchange between respectively the first mode and the second mode when a predetermined current is applied. The Josephson junctions 801 and 802 are substantially identical and the capacitive elements 804 and 805 are also substantially identical. Hence, the symmetry of the circuit implies that the actual modes of the system are actually the symmetric 806 and anti-symmetric 807 superposition of the two resonators. The first mode is the symmetric one indicated with solid arrows and the second mode is the antisymmetric one indicated with dashed arrows. One can notice that only the antisymmetric mode has a contribution across the central inductive element 803. This contribution is advantageously used to couple the environment preferentially to the second mode.

There is no optimal bias point in this circuit. Indeed, the junction cannot be both biased to *φ_{DC}* = π/2 and maximal budget of *φₑₓₜ* = *π* (since there has to be non-zero phase drop across the inductor). However, this is not problematic as an optimal bias point is neither wanted. Indeed, at such a point, the Josephson junction acts as an open circuit and thus only the parallel Josephson capacitance remains, which is in contradiction with the fact that, in this particular circuit, the junction serves as a primary inductive element for the symmetric mode. By adding one loop, one could enable an optimal bias point. An example implementation consists in a symmetrized version of the circuits of FIG.s 4a and 4b where both resonators are made identical and non-linear by replacing inductance 605 by the loop 610. As proposed in FIG.s 4a and 4b, the coupling between the two non-linear identical resonators can be capacitive or inductive.

Here the circuit 800 consists of two identical resonators that are strongly coupled via the central inductive element. This implies that the bare (before adding the coupling) detuning between the two resonators is zero and that the perturbative description performed for circuit 600 does not hold any more. Hence, the analysis presented here is different as the circuit 600. Assuming the system is perfectly symmetric (both junctions and both capacitances are identical), the system may be decomposed into a symmetric mode (i.e., the first mode *a*) and a anti-symmetric mode (i.e., the second mode *b*). In this eigenmode basis, one can compute the contribution of each junction to the Hamiltonian of the system: $\begin{matrix}{H}_{J} = - {E}_{J} cos \left({φ}_{DC}+{φ}_{a}\left(a+{a}^{†}\right)+{φ}_{b}\left(b+{b}^{†}\right)\right) - \\ {E}_{J} cos \left(-{φ}_{DC}9+{φ}_{a}\left(a+{a}^{†}\right)-{φ}_{b}\left(b+{b}^{†}\right)\right)\end{matrix}$ which can be factored as: $\begin{matrix}{H}_{J} = - 2 {E}_{J} cos \left({φ}_{DC}\right) cos \left({φ}_{a}\left(a+{a}^{†}\right)\right) cos \left({φ}_{b}\left(b+{b}^{†}\right)\right) \\ + 2 {E}_{J} sin \left({φ}_{DC}\right) cos \left({φ}_{a}\left(a+{a}^{†}\right)\right) sin \left({φ}_{b}\left(b+{b}^{†}\right)\right)\end{matrix}$ The two quadratic part of the first term gives the effective inductive energy of the junction at the working point of the system *2E_{J}* cos( *φ_{DC}*). Together with the charging energy of the capacitors and the inductive energy of the central inductive element, it enables us to define the frequencies ${ω}_{a} = \sqrt{16 {E}_{C} {E}_{J} cos \left({φ}_{DC}\right)} and {ω}_{b} = \sqrt{16 {E}_{C} \left({E}_{J} cos\left({φ}_{DC}\right)+2{E}_{L}\right)}$ and the zero point fluctuation of the phase ${φ}_{a} = {\left(\frac{{E}_{C}}{{E}_{J} cos \left({φ}_{DC}\right)}\right)}^{1 / 4} and {φ}_{b} = {\left(\frac{{E}_{C}}{{E}_{J} cos \left({φ}_{DC}\right) + 2 {E}_{L}}\right)}^{1 / 4} .$

By expanding the second term at the desired order one can get the resonant 2N-to-1 photon exchange Hamiltonian ${H}_{NL} = {ℏg}_{2 N} {a}^{2 N} {b}^{†} + h . c .$ with ${ℏg}_{2 N} = 2 {E}_{J} sin \left({φ}_{DC}\right) \frac{{φ}_{a}^{2 N} {φ}_{b}}{2 N !}$.

Because of the symmetry of the system and the frequency matching condition that must be satisfied at the bias point of the system, the expression may be further simplified. Indeed, since *2Nωₐ = ω_{b},* it can be obtained that 4*N*²*E_{J}* cos(φ*_{DC}*) = *E_{J}* cos(*φ_{DC}) + 2E_{L}* and hence ${φ}_{a} = \sqrt{2 N} {φ}_{b}$ leading to ${ℏg}_{2 N} = \sqrt{\frac{2}{N}} {E}_{J} sin \left({φ}_{DC}\right) \frac{{φ}_{a}^{2 N}}{2 N !}$

FIG. 8b shows an example of the device used to stabilize a manifold of coherent states with the circuit 800. Looking at the figure from bottom to top, at the bottom of FIG. 8b lies the non-linear superconducting circuit 800. At the top, the inductive element shares a mutual inductance 808 with another inductor that terminates the environment 820. The environment 820 consists of a load, a microwave source and a DC current source. In the same way as before, the same input port of the device can conveniently be used to bring DC current for external flux and microwave radiation. In practice, as before a portion of transmission line is used to connect the circuit to the environment. This portion of transmission line closest to the circuit 809 is typically a differential transmission line in order to preserve the symmetries of the circuit 800.

FIG. 8c shows an example of the planar superconducting pattern 850 and circuit equivalent. The presented superconducting circuit is fabricated in a coplanar waveguide geometry (CPW) where the background (greyed out part) represents the superconducting metal left on the dielectric substrate. Each cross in black represents a respective Josephson junction. In contrast with the device of FIG. 8b, the inductive element is replaced with a single junction. In this circuit, in order to control the level of non-linearity of the system, the central superconducting loop 810 is diluted by using three portions of CPW transmissions called stubs (811, 812, 813). On the left and on the right (811, 812), open stubs provide the required capacitance with some stray inductance in series. On the bottom, the ring is not directly connected to ground and a shorted stub 813 is interleaved to provide inductance to ground. The modes of the circuit and its working principle remains the same but the lengths of transmission line added by the stubs enable to limit the level of non-linearity of the circuit. In order to couple preferentially to the second mode and preserve the symmetry of the circuit, a transmission slotline 809 is used to inductively couple to the modes to the environment. A transition between CPW and slotline 814 is represented above, in order to couple to the environment (and thus the current source) that have a common geometry 815 (e.g., CPW lines or coaxial cables).

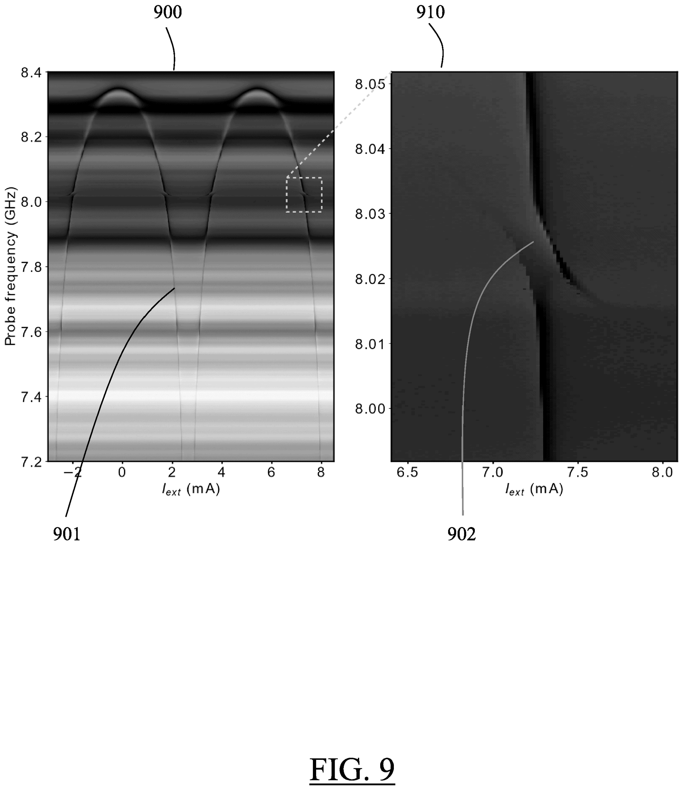

FIG. 9 illustrates experimental data demonstrating the intrinsic 2-to-1 photon dynamics in a tested implementation (that is, non-linear anti-crossing when the predetermined current biases the circuit). The data has been taken on a device represented by the planar superconducting pattern 850 made out of tantalum on a sapphire substrate with Josephson junctions made of aluminum and aluminum oxide. The parameters of the symbolic representation are the following. The Josephson energy of the pair of junction is *E_{J}* = 250 GHz and the central inductive element is made of a single Josephson junction with energy *E_{L}* = 120 GHz. The side capacitances have an energy *E_{C} =* 40 MHz with stray series inductance *E_{Lc}* = 400 GHz. The inductance to ground has an energy *E_{Lg}* = 150 GHz with stray capacitance *E_{Cg}* = 125 MHz. The colormap 900 corresponds to the amplitude of the reflected microwave signal from the microwave source on the non-linear superconducting circuit as a function of the source frequency and bias current *Iₑₓₜ.* The line 901 corresponds to the place the probe frequency matches the second mode frequency and hence shows the frequency of the second mode as a function of bias current just as in FIG. 4. A zoomed portion 910 in the anti-crossing 902 happens when the two modes of the circuit fulfil the frequency matching condition *2ωₐ = ω_{b}.* In this device, the bias point is around 7.3 mA.

## Claims

1. A non-linear superconducting quantum circuit (100, 600, 700, 800) comprising components which host a first mode and a second mode, each of the first mode and the second mode having a respective resonant frequency, wherein the circuit (100, 600, 700, 800) further comprises:
(i) at least one superconducting loop (610, 710, 810) including one or more Josephson junctions each having a respective tunable inductance affecting the resonant frequency of the first and/or second mode when a predetermined current of a constant intensity is applied to the circuit, and
(ii) a SQUID comprising two Josephson junctions in parallel affecting the resonant frequency of the second mode when an external current biases the SQUID,
the circuit (100, 600, 700, 800) being configured such that, when the predetermined current of a constant intensity is applied to the circuit and the external current biases the SQUID, the resonant frequency of the second mode is substantially 2N times the resonant frequency of the first mode, the circuit (100, 600, 700, 800) thereby performing intrinsically a resonant 2N-to-1 photon exchange between respectively the first mode and the second mode, N being a positive integer.

2. The non-linear superconducting quantum circuit of claim 1, wherein the circuit (100, 600, 700, 800) has, when the currents are applied to the circuit (100, 600, 700, 800), a Hamiltonian which is a function of a set of parameters that consists of parameters of the circuit (100, 600, 700, 800) and parameters of the currents, wherein the Hamiltonian is expandable into a sum between at least a dominant term of the form ${ℏg}_{2 N} {a}^{2 N} {b}^{†} + {ℏg}_{2 N}^{∗} {a}^{† 2 N} b$ and a series of subsidiary terms, where *g*_{2*N*} is a scalar corresponding to the intrinsic coupling strength, *a* is the annihilation operator of the first mode, *b* is the annihilation operator of the second mode, and ℏ is the reduced Planck constant.

3. The non-linear superconducting quantum circuit of any one of the preceding claims, wherein the at least one superconducting loop (610) includes a first Josephson junction (601) arranged in parallel with a first inductive element (602) and a first capacitive element (603) comprising respective first and second extremum nodes, the circuit (100, 600, 700, 800) also comprising:
• a second inductive element (605) and a second capacitive element (604) arranged in parallel, comprising respective first and second extremum nodes, and
• a linear coupling element, the linear coupling element being either a capacitive element (606) or an inductive element (607);
wherein the respective first extremum node of the superconducting loop (610) is connected to the respective first extremum node of the second inductive element (605) and the second capacitive element (604) arranged in parallel (620) via the linear coupling element (606-607), and the respective second extremum node of the superconducting loop (610) and the respective second extremum node of the second inductive element (605) and the second capacitive element (604) being arranged in parallel are connected to a common ground.

4. The non-linear superconducting quantum circuit (600-630) of claim 3, wherein, when the currents are applied to the circuit, the Hamiltonian of the circuit has:
• a linear term describing the first mode and the second mode of the type *H*ₗᵢₙ *= ℏωₐa*^{†}*a + ℏω_{b}b*^{†}*b,* where $\frac{{ω}_{a}}{2 π}$ is the resonant frequency of the first mode and $\frac{{ω}_{b}}{2 π}$ is the resonant frequency of the second mode,
• at least one non-linear term of the form *E_{J}* sin(*φ_{DC}*) sin (*φₐ* ((*a + a*^{†}) *+ ε*(*b + b^{†}*))) or of the form *E_{J}* sin(*φ_{DC}*) sin (*φ_{b}*((*b + b*^{†}) *+ ε*(*a + a*^{†}))), where:
∘ *Eⱼ* is the energy of the Josephson junction,
∘ *φ_{DC}* is the phase difference across the Josephson junction induced by the predetermined current,
∘ *φₐ* is the zero-point fluctuation of the phase across the Josephson junction associated to the first mode or *φ_{b}* is the zero-point fluctuation of the phase across the Josephson junction associated to the second mode, and
∘ *ε* describes a linear coupling between the first and second mode,
• the circuit (600-630) thereby having a Hamiltonian, being expandable into a sum comprising at least a dominant term which is a non-linear resonant term of the type ${ℏg}_{2 N} {a}^{2 N} {b}^{†} + {ℏg}_{2 N}^{∗} {a}^{† 2 N} b$ with ${ℏg}_{2 N} = {E}_{J} sin \left({φ}_{DC}\right) ϵ \frac{{φ}_{a}^{2 N + 1}}{2 N !}$ or ${ℏg}_{2 N} = {E}_{J} sin \left({φ}_{DC}\right) {ϵ}^{2 N} \frac{{φ}_{b}^{2 N + 1}}{2 N !}$ , where the resonant condition 2*Nωₐ = ω_{b}* is obtained by the application of the currents.

5. The non-linear superconducting quantum circuit (700) of claims 1 or 2, wherein the at least one superconducting loop (710) includes a Josephson junction (701), a first inductive element (702) and a second inductive element (703) arranged in a series topology, the series topology comprising:
• a first inner node connecting a pole of the Josephson junction (701) with a pole of the first inductive element (702),
• a second inner node connecting another pole of the Josephson junction (701) with a pole of the second inductive element (703),
• a closed-loop node connecting another pole of the first inductive element (702) with another pole of the second inductive element (703);
the at least one superconducting loop being connected to a common ground via the closed-loop node;
the circuit also comprising a first capacitor (704) and a second capacitor (705) where:
• the first capacitor (704) is connected in parallel with the first inductive element (702) between the common ground and the first inner node of the superconducting loop, and
• the second capacitor (705) is connected in parallel with the second inductive element (703), between the common ground and the second inner node of the superconducting loop.

6. The non-linear superconducting quantum circuit (700) of claim 5, wherein, when the currents are applied to the circuit, the Hamiltonian of the circuit has:
• a linear term describing the first mode and the second mode of the type *H*ₗᵢₙ → *ℏωₐa*^{†}*a + ℏω_{b}b*^{†}*b,* where $\frac{{ω}_{a}}{2 π}$ is the resonant frequency of the first mode and $\frac{{ω}_{b}}{2 π}$ is the resonant frequency of the second mode,
• at least one non-linear term of the form *E_{J}* sin(*φ_{DC}*) sin (*φₐ*(*a* + *a*^{†}) *+ φ_{b}*(*b* + *b*^{†})) where:
∘ *E_{J}* is the energy of the Josephson junction,
∘ *φ_{DC}* is the phase difference across the Josephson junction induced by the predetermined current, and
∘ *φₐ* is the zero-point fluctuation of the phase across the Josephson junction associated to the first mode and *φ*_{b} is the zero-point fluctuation of the phase across the Josephson junction associated to the second mode;
the circuit (700) thereby having a Hamiltonian being expandable into a sum comprising at least dominant term which is a non-linear resonant term of the type ${ℏg}_{2 N} {a}^{2 N} {b}^{†} + {ℏg}_{2 N}^{∗} {a}^{† 2 N} b$ with ${ℏg}_{2 N} = \frac{2 {E}_{J} sin \left({φ}_{DC}\right) {φ}_{a}^{2 N} {φ}_{b}}{\left(2N\right) !}$, where the resonant condition 2*Nωₐ = ω_{b}* is obtained by the application of the currents.

7. The non-linear superconducting quantum circuit (800) of claims 1 or 2, wherein the at least one superconducting loop (810) includes a first Josephson junction (801), a central inductive element (803), and a second Josephson junction (802) arranged in a series topology, the series topology comprising:
• a first inner node connecting a pole of the first Josephson junction (801) with a pole of the inductive element (803),
• a second inner node connecting a pole of the second Josephson junction (802) with another pole of the inductive element (803),
• a closed-loop node connecting another pole of the first Josephson junction (801) with another pole of the second Josephson junction (802);
the at least one superconducting loop (810) being connected to a common ground via the closed-loop node;
the circuit (800) also comprising a first capacitor (804) and a second capacitor (805), where:
• the first capacitor (804) is connected in parallel with the first Josephson junction (801) between the common ground and the first inner node of the superconducting loop (810), and
• the second capacitor (805) is connected in parallel with the second Josephson junction (802) between the common ground and the second inner node of the superconducting loop (810).

8. The non-linear superconducting quantum circuit (800) of claim 7, wherein, when the predetermined current of a constant intensity is applied to the circuit, the Hamiltonian of the circuit has:
• a linear term describing the first mode and the second mode of the type *H*ₗᵢₙ → *ℏωₐa*^{†}*a + ℏω_{b}b*^{†}*b,* where $\frac{{ω}_{a}}{2 π}$ is the frequency of the first mode and $\frac{{ω}_{b}}{2 π}$ is the frequency of the second mode,
• at least one non-linear term of the form *E_{J}* sin(*φ_{DC}*) cos (*φₐ*(*a +* a^{†}))sin(*φ_{b}*(*b* + *b*^{†})), where:
∘ *E_{J}* is the energy of the first and/or second Josephson junction,
∘ *φ*_{*J*0} is the phase difference across the first and/or second Josephson junction induced by the predetermined current, and
∘ *φₐ* is the zero-point fluctuation of the phase across the Josephson junction associated to the first mode and *φ_{b}* is the zero-point fluctuation of the phase across the Josephson junction associated to the second mode;
the circuit (800) thereby having a Hamiltonian being expandable into a sum comprising at least a dominant term which is a non-linear resonant term of the type ${ℏg}_{2 N} {a}^{2 N} {b}^{†} + {ℏg}_{2 N}^{∗} {a}^{† 2 N} b$ with ${ℏg}_{2 N} = 2 {E}_{J} sin \left({φ}_{DC}\right) \frac{{φ}_{a}^{2 N} {φ}_{b}}{\left(2N\right) !}$*,* where the resonant condition 2*Nωₐ* = *ω_{b}* is obtained by the application of the currents.

9. A device comprising:
a non-linear superconducting quantum circuit (100, 600, 700, 800) according to any of claims 1 to 8; and
current sources configured to apply the predetermined current of a constant intensity to the circuit (100, 600, 700, 800) and the external current to bias the SQUID.

10. The device of claim 9, further comprising:
a load (105),
a microwave source (106) configured to apply a microwave radiation at a frequency substantially equal to the resonant frequency of the second mode or 2N times the resonant frequency of the first mode,
a coupler (104) configured for coupling the second mode of the circuit (100, 600, 700, 800) to the load (105) and to the microwave source (106); and
wherein, optionally:
the load (105) is either a resistor, a matched transmission line or a matched waveguide,
the device further comprises a band pass (210) or a band stop (220) filter connected to the first and the second mode of the circuit (100, 600, 700, 800), the band pass (210) or the band stop (220) filter being configured for only allowing the coupling of the second mode to the load, and/or
the geometry and/or symmetry of the coupler (104) is such that it couples only to the second mode.

11. A quantum computing system comprising at least one non-linear superconducting quantum circuit (100, 600, 700, 800) according to any one of claims 1 to 8 and/or a device according to claim 9 or 10.

12. A method comprising:
• providing a non-linear superconducting quantum circuit (100, 600, 700, 800) according to any one of claims 1 to 8, a device according to claim 9 or 10, or a quantum computing system according to claim 11, and
• tuning the respective tunable inductance of each of the one or more Josephson junctions by applying predetermined current of a constant intensity to the circuit (100, 600, 700, 800) and affecting the resonant frequency of the second mode by applying the external current to bias the SQUID such that the resonant frequency of the second mode is substantially 2N times the resonant frequency of the first mode, such that the circuit performs the intrinsically resonant 2N-to-1 photon exchange between respectively the first mode and the second mode.

13. The method of claim 12, wherein the method comprises providing a device according to claim 10 or a quantum computing system comprising a device according to claim 10, the method being used to stabilize a quantum manifold spanned by 2N coherent states with a same amplitude and a *π*/*N* phase difference, so as to enable encoding of quantum information in the form of a cat-qubit.

## Patentansprüche

1. Nichtlinearer supraleitender Quantenschaltkreis (100, 600, 700, 800), umfassend Komponenten, die einen ersten Modus und einen zweiten Modus bieten, wobei sowohl der erste Modus als auch der zweite Modus eine jeweilige Resonanzfrequenz aufweist, wobei die Schaltung (100, 600, 700, 800) weiter umfasst:
(i) mindestens eine supraleitende Schleife (610, 710, 810), die einen oder mehrere Josephson-Kontakte beinhaltet, die jeweils eine jeweilige einstellbare Induktivität aufweisen, die die Resonanzfrequenz des ersten und/oder des zweiten Modus veranlasst, wenn ein vorbestimmter Strom mit einer konstanten Intensität an den Schaltkreis angelegt wird, und
(ii) einen SQUID, der zwei Josephson-Kontakte parallel umfasst, die die Resonanzfrequenz des zweiten Modus veranlassen, wenn ein externer Strom den SQUID vorspannt,
der Schaltkreis (100, 600, 700, 800) so konfiguriert ist, wenn ein vorbestimmter Strom einer konstanten Intensität an dien Schaltkreis angelegt wird und der externe Strom den SQUID vorspannt, ist die Resonanzfrequenz des zweiten Modus im Wesentlichen das 2N-Fache der Resonanzfrequenz des ersten Modus, wodurch der Schaltkreis (100, 600, 700, 800) einen resonanten 2N-zu-1-Photonenaustausch zwischen dem ersten Modus beziehungsweise dem zweiten Modus intrinsisch durchführt, wobei N eine positive ganze Zahl ist.

2. Nichtlinearer supraleitender Quantenschaltkreis nach Anspruch 1, wobei der Schaltkreis (100, 600, 700, 800), wenn die Ströme an den Schaltkreis (100, 600, 700, 800) angelegt werden, einen Hamiltonoperator aufweist, der eine Funktion eines Parametersatzes ist, der aus Parametern des Schaltkreises (100, 600, 700, 800) und Parametern der Ströme besteht, wobei der Hamiltonoperator zu einer Summe zwischen mindestens einem dominanten Term der Form ${ℏg}_{2 N} {a}^{2 N} {b}^{†} + {ℏg}_{2 N}^{∗} {a}^{† 2 N} b$ und einer Reihe von Hilfstermen erweitert werden kann, wobei *g*_{2*N*} ein Skalar ist, der der intrinsischen Kopplungsstärke entspricht, *a* der Vernichtungsoperator des ersten Modus ist, *b* der Vernichtungsoperator des zweiten Modus ist und ℏ die reduzierte Planck-Konstante ist.

3. Nichtlinearer supraleitender Quantenschaltkreis nach einem vorstehenden Anspruch, wobei die mindestens eine supraleitende Schleife (610) einen ersten Josephson-Kontakt (601) beinhaltet, der parallel zu einem ersten induktiven Element (602) und einem ersten kapazitiven Element (603) angeordnet ist, die jeweils einen ersten und einen zweiten Extremumknoten umfassen, wobei der Schaltkreis (100, 600, 700, 800) außerdem Folgendes umfasst:
- ein zweites induktives Element (605) und ein zweites kapazitives Element (604), die parallel angeordnet sind, wobei sie jeweils einen ersten und einen zweiten Extremumknoten umfassen, und
- ein lineares Kopplungselement, wobei das lineare Kopplungselement entweder ein kapazitives Element (606) oder ein induktives Element (607) ist;
wobei der jeweilige erste Extremumknoten der supraleitenden Schleife (610) über das lineare Kopplungselement (606-607) mit dem jeweiligen ersten Extremumknoten des zweiten induktiven Elements (605) und des zweiten kapazitiven Elements (604) verbunden ist, die parallel angeordnet sind (620), und der jeweilige zweite Extremumknoten der supraleitenden Schleife (610) und der jeweilige zweite Extremumknoten des zweiten induktiven Elements (605) und des zweiten kapazitiven Elements (604), die parallel (620) angeordnet sind, mit einer gemeinsamen Masse verbunden sind.

4. Nichtlinearer supraleitender Quantenschaltkreis (600-630) nach Anspruch 3, wobei, wenn die Ströme an den Schaltkreis angelegt werden, der Hamiltonoperator des Schaltkreises Folgendes aufweist:
- einen linearen Term, der den ersten Modus und den zweiten Modus vom Typ *H*ₗᵢₙ = *ℏωₐa*^{†}*a + ℏω_{b}b*^{†}*b* beschreibt, wobei $\frac{{ω}_{a}}{2 π}$ die Resonanzfrequenz des ersten Modus und $\frac{{ω}_{b}}{2 π}$ die Resonanzfrequenz des zweiten Modus ist,
- mindestens einen nichtlinearen Term der Form *E_{J}sin*(*φ_{DC}*)sin(*φₐ*((*a + a*^{†}) *+ ε*(*b + b*^{†}))) oder der Form *E_{J}*sin(*φ_{DC}*)sin(*φ_{b}*((*b + b*^{†}) *+ ε*(*a + a*^{†}))), wobei:
- *E_{J}* die Energie des Josephson-Kontakts ist,
- *φ_{DC}* die durch den vorbestimmten Strom induzierte Phasendifferenz über den Josephson-Kontakt ist,
- *φₐ* die Nullpunktsfluktuation der Phase über den Josephson-Kontakt ist, die dem ersten Modus zugeordnet ist, oder *φ_{b}* die Nullpunktsfluktuation der Phase über den Josephson-Kontakt ist, die dem zweiten Modus zugeordnet ist, und
- *ε* eine lineare Kopplung zwischen dem ersten und zweiten Modus beschreibt,
der Schaltkreis (600-630) somit einen Hamiltonoperator aufweist, der zu einer Summe erweitert werden kann, die mindestens einen dominanten Term umfasst, der ein nichtlinearer Resonanzterm vom Typ ${ℏg}_{2 N} {a}^{2 N} {b}^{†} + {ℏg}_{2 N}^{∗} {a}^{† 2 N} b$ mit ${ℏg}_{2 N} = {E}_{j} sin \left({φ}_{DC}\right) ϵ \frac{{φ}_{a}^{2 N + 1}}{2 N !}$ oder ${ℏg}_{2 N} = {E}_{j} sin \left({φ}_{DC}\right) {ϵ}^{2 N} \frac{{φ}_{b}^{2 N + 1}}{2 N !}$ ist, wobei die Resonanzbedingung 2*Nωₐ = ω_{b}* durch das Anlegen der Ströme erhalten wird.

5. Nichtlinearer supraleitender Quantenschaltkreis (700) nach Anspruch 1 oder 2, wobei die mindestens eine supraleitende Schleife (710) einen Josephson-Kontakt (701), ein erstes induktives Element (702) und ein zweites induktives Element (703) beinhaltet, die in einer Reihentopologie angeordnet sind, wobei die Reihentopologie Folgendes umfasst:
- einen ersten inneren Knoten, der einen Pol des Josephson-Kontakts (701) mit einem Pol des ersten induktiven Elements (702) verbindet,
- einen zweiten inneren Knoten, der einen anderen Pol des Josephson-Kontakts (701) mit einem Pol des zweiten induktiven Elements (703) verbindet,
- einen geschlossenen Schleifenknoten, der einen anderen Pol des ersten induktiven Elements (702) mit einem anderen Pol des zweiten induktiven Elements (703) verbindet;
wobei die mindestens eine supraleitende Schleife über den geschlossenen Schleifenknoten mit einer gemeinsamen Masse verbunden ist;
der Schaltkreis außerdem einen ersten Kondensator (704) und einen zweiten Kondensator (705) umfasst, wobei:
- der erste Kondensator (704) parallel zum ersten induktiven Element (702) zwischen der gemeinsamen Masse und dem ersten inneren Knoten der supraleitenden Schleife verbunden ist, und
- der zweite Kondensator (705) parallel zum zweiten induktiven Element (703) zwischen der gemeinsamen Masse und dem zweiten inneren Knoten der supraleitenden Schleife verbunden ist.

6. Nichtlinearer supraleitender Quantenschaltkreis (700) nach Anspruch 5, wobei, wenn der vorbestimmte Strom einer konstanten Intensität an den Schaltkreis angelegt wird, der Hamiltonoperator des Schaltkreises Folgendes aufweist:
- einen linearen Term, der den ersten Modus und den zweiten Modus vom Typ *H*ₗᵢₙ = ℏωₐ*a*^{†}*a* + ℏ*ω_{b}b*^{†}*b* beschreibt, wobei $\frac{{ω}_{a}}{2 π}$ die Resonanzfrequenz des ersten Modus und $\frac{{ω}_{b}}{2 π}$ die Resonanzfrequenz des zweiten Modus ist,
- mindestens einen nichtlinearen Term der Form *Eⱼ*sin(*φ*_{DC})sin(*φ*ₐ(*a* + *a*^{†}) + *φ_{b}*(*b* + *b*^{†})), wobei:
- *Eⱼ* die Energie des Josephson-Kontakts ist,
- *φ_{DC}* die durch den vorbestimmten Strom induzierte Phasendifferenz über den Josephson-Kontakt ist, und
- *φₐ* die Nullpunktsfluktuation der Phase über den Josephson-Kontakt ist, die dem ersten Modus zugeordnet ist, und *φ_{b}* die Nullpunktsfluktuation der Phase über den Josephson-Kontakt ist, die dem zweiten Modus zugeordnet ist;
der Schaltkreis (700) somit einen Hamiltonoperator aufweist, der zu einer Summe erweitert werden kann, die mindestens einen dominanten Term umfasst, der ein nichtlinearer Resonanzterm vom Typ ${ℏg}_{2 N} {a}^{2 N} {b}^{†} + {ℏg}_{2 N}^{∗} {a}^{† 2 N} b$ mit ${ℏg}_{2 N} = \frac{2 {E}_{j} sin \left({φ}_{DC}\right) {φ}_{a}^{2 N} {φ}_{b}}{\left(2N\right) !}$ ist, wobei die Resonanzbedingung 2*Nω*ₐ = *ω_{b}* durch das Anlegen der Ströme erhalten wird.

7. Nichtlinearer supraleitender Quantenschaltkreis (800) nach Anspruch 1 oder 2, wobei die mindestens eine supraleitende Schleife (810) einen ersten Josephson-Kontakt (801), ein mittiges induktives Element (803) und einen zweiten Josephson-Kontakt (802) beinhaltet, die in einer Reihentopologie angeordnet sind, wobei die Reihentopologie Folgendes umfasst:
- einen ersten inneren Knoten, der einen Pol des ersten Josephson-Kontakts (801) mit einem Pol des induktiven Elements (803) verbindet,
- einen zweiten inneren Knoten, der einen Pol des zweiten Josephson-Kontakts (802) mit einem anderen Pol des induktiven Elements (803) verbindet,
- einen geschlossenen Schleifenknoten, der einen anderen Pol des ersten Josephson-Knotens (801) mit einem anderen Pol des zweiten Josephson-Knotens (802) verbindet;
wobei die mindestens eine supraleitende Schleife (810) über den geschlossenen Schleifenknoten mit einer gemeinsamen Masse verbunden ist;
der Schaltkreis (800) außerdem einen ersten Kondensator (804) und einen zweiten Kondensator (805) umfasst, wobei:
- der erste Kondensator (804) parallel zum ersten Josephson-Kontakt (801) zwischen der gemeinsamen Masse und dem ersten inneren Knoten der supraleitenden Schleife (810) verbunden ist, und
- der zweite Kondensator (805) parallel zum zweiten Josephson-Kontakt (802) zwischen der gemeinsamen Masse und dem zweiten inneren Knoten der supraleitenden Schleife (810) verbunden ist.

8. Nichtlinearer supraleitender Quantenschaltkreis (800) nach Anspruch 7, wobei, wenn der vorbestimmte Strom einer konstanten Intensität an den Schaltkreis angelegt wird, der Hamiltonoperator des Schaltkreises Folgendes aufweist:
- einen linearen Term, der den ersten Modus und den zweiten Modus vom Typ *H*ₗᵢₙ = *ℏωₐa*^{†}*a + ℏω_{b}b*^{†}*b* beschreibt, wobei $\frac{{ω}_{a}}{2 π}$ die Frequenz des ersten Modus und $\frac{{ω}_{b}}{2 π}$ die Frequenz des zweiten Modus ist,
- mindestens einen nichtlinearen Term der Form *Eⱼsin*(*φ_{DC}*)*cos*(*φₐ*(*a + a*^{†}))sin(*φ_{b}*(*b + b*^{†})), wobei:
- *Eⱼ* die Energie des ersten und/oder zweiten Josephson-Kontakts ist,
- *φ*_{*J*0} die durch den vorbestimmten Strom induzierte Phasendifferenz über den ersten und/oder zweiten Josephson-Kontakt ist, und
- *φₐ* die Nullpunktsfluktuation der Phase über den Josephson-Kontakt ist, die dem ersten Modus zugeordnet ist, und *φ_{b}* die Nullpunktsfluktuation der Phase über den Josephson-Kontakt ist, die dem zweiten Modus zugeordnet ist;
der Schaltkreis (800) somit einen Hamiltonoperator aufweist, der zu einer Summe erweitert werden kann, die mindestens einen dominanten Term umfasst, der ein nichtlinearer Resonanzterm vom Typ ${ℏg}_{2 N} {a}^{2 N} {b}^{†} + {ℏg}_{2 N}^{∗} {a}^{† 2 N} b$ mit ${ℏg}_{2 N} = 2 {E}_{j} sin \left({φ}_{DC}\right) \frac{{φ}_{a}^{2 N} {φ}_{b}}{\left(2N\right) !}$ ist, wobei die Resonanzbedingung *ZNωₐ = ω_{b}* durch das Anlegen des vorbestimmten Stroms erhalten wird.

9. Vorrichtung, umfassend:
einen nichtlinearen supraleitenden Quantenschaltkreis (100, 600, 700, 800) nach einem der Ansprüche 1 bis 8; und
Stromquellen, die dazu konfiguriert sind, den vorbestimmten Strom einer konstanten Intensität an den Stromkreis (100, 600, 700, 800) und den externen Strom, um den SQUID vorzuspannen, anzulegen.

10. Vorrichtung nach Anspruch 9, weiter umfassend:
eine Last (105),
eine Mikrowellenquelle (106), die dazu konfiguriert ist, eine Mikrowellenstrahlung mit einer Frequenz anzulegen, die im Wesentlichen der Resonanzfrequenz des zweiten Modus oder dem 2N-Fachen der Resonanzfrequenz des ersten Modus gleich ist,
einen Koppler (104), der dazu konfiguriert ist, den zweiten Modus des Schaltkreises (100, 600, 700, 800) mit der Last (105) und der Mikrowellenquelle (106) zu koppeln; und
wobei optional:
die Last (105) entweder ein Widerstand, eine angepasste Übertragungsleitung oder ein angepasster Wellenleiter ist,
die Vorrichtung weiter einen Bandpassfilter (210) oder einen Bandsperrfilter (220) umfasst, der mit dem ersten und dem zweiten Modus des Schaltkreises (100, 600, 700, 800) verbunden ist, wobei der Bandpassfilter (210) oder der Bandsperrfilter (220) dazu konfiguriert ist, nur die Kopplung des zweiten Modus an die Last zuzulassen, und/oder
die Geometrie und/oder Symmetrie des Kopplers (104) so ist, dass er sich nur mit dem zweiten Modus koppelt.

11. Quantencomputersystem, das mindestens einen nichtlinearen supraleitenden Quantenschaltkreis (100, 600, 700, 800) nach einem der Ansprüche 1 bis 8 und/oder eine Vorrichtung nach Anspruch 9 oder 10 umfasst.

12. Verfahren, umfassend:
- Bereitstellen eines nichtlinearen supraleitenden Quantenschaltkreises (100, 600, 700, 800) nach einem der Ansprüche 1 bis 8, einer Vorrichtung nach Anspruch 9 oder 10 oder eines Quantencomputersystems nach Anspruch 11, und
- Einstellen der jeweiligen einstellbaren Induktivität jedes des einen oder der mehreren Josephson-Kontakte durch Anlegen eines vorbestimmten Stroms einer konstanten Intensität an den Schaltkreis (100, 600, 700, 800) und Veranlassen der Resonanzfrequenz des zweiten Modus durch Anlegen des externen Stroms, um den SQUID vorzuspannen, sodass die Resonanzfrequenz des zweiten Modus im Wesentlichen das 2N-Fache der Resonanzfrequenz des ersten Modus ist, sodass der Schaltkreis den intrinsisch resonanten 2N-zu-1-Photonenaustausch zwischen dem ersten Modus beziehungsweise dem zweiten Modus durchführt.

13. Verfahren nach Anspruch 12, wobei das Verfahren Bereitstellen einer Vorrichtung nach Anspruch 10 oder eines Quantencomputersystems umfasst, das eine Vorrichtung nach Anspruch 10 umfasst, wobei das Verfahren zum Stabilisieren eines Quantenraums verwendet wird, der von 2N kohärenten Zuständen mit einer gleichen Amplitude und einer *π*/*N* Phasendifferenz aufgespannt wird, um Kodierung von Quanteninformationen in der Form eines Katzen-Qubits zu ermöglichen.

## Revendications

1. Circuit quantique supraconducteur non linéaire (100, 600, 700, 800) comprenant des composants qui hébergent un premier mode et un second mode, chacun du premier mode et du second mode présentant une fréquence de résonance respective, dans lequel le circuit (100, 600, 700, 800) comprend en outre :
(i) au moins une boucle supraconductrice (610, 710, 810) incluant une ou plusieurs jonctions Josephson présentant chacune une inductance ajustable affectant la fréquence de résonance du premier mode et/ou du second mode lorsqu'un courant prédéterminé d'intensité constante est appliqué au circuit, et
(ii) un SQUID comprenant deux jonctions Josephson en parallèle affectant la fréquence de résonance du second mode lorsqu'un courant externe polarise le SQUID,
le circuit (100, 600, 700, 800) étant configuré de sorte que, lorsque le courant prédéterminé d'intensité constante est appliqué au circuit et le courant externe polarise le SQUID, la fréquence de résonance du second mode soit sensiblement 2N fois la fréquence de résonance du premier mode, le circuit (100, 600, 700, 800) réalisant ainsi intrinsèquement un échange de photons résonant 2N à 1 entre respectivement le premier mode et le second mode, N étant un entier positif.

2. Circuit quantique supraconducteur non linéaire selon la revendication 1, dans lequel le circuit (100, 600, 700, 800) présente, lorsque les courants sont appliqués au circuit (100, 600, 700, 800), un hamiltonien qui est une fonction d'un ensemble de paramètres qui se compose de paramètres du circuit (100, 600, 700, 800) et de paramètres des courants, dans lequel l'hamiltonien est extensible en une somme entre au moins un terme dominant de la forme ${ℏg}_{2 N} {a}^{2 N} {b}^{†} + {ℏg}_{2 N}^{∗} {a}^{† 2 N} b$ et une série de termes subsidiaires, où *g*_{2*N*} est un scalaire correspondant à la force de couplage intrinsèque, *a* est l'opérateur d'annihilation du premier mode, *b* est l'opérateur d'annihilation du second mode et ℏ est la constante de Planck réduite.

3. Circuit quantique supraconducteur non linéaire selon l'une quelconque des revendications précédentes, dans lequel l'au moins une boucle supraconductrice (610) inclut une première jonction Josephson (601) agencée en parallèle avec un premier élément inductif (602) et un premier élément capacitif (603) comprenant des premier et second nœuds extrêmes respectifs, le circuit (100, 600, 700, 800) comprenant également :
- un second élément inductif (605) et un second élément capacitif (604) agencés en parallèle, comprenant respectivement des premier et second nœuds extrêmes, et
- un élément de couplage linéaire, l'élément de couplage linéaire étant soit un élément capacitif (606), soit un élément inductif (607) ;
dans lequel le premier nœud extrême respectif de la boucle supraconductrice (610) est connecté au premier nœud extrême respectif du second élément inductif (605) et du second élément capacitif (604) agencés en parallèle (620) par l'intermédiaire de l'élément de couplage linéaire (606-607), et le second nœud extrême respectif de la boucle supraconductrice (610) et le second nœud extrême respectif du second élément inductif (605) et du second élément capacitif (604) étant agencés en parallèle sont connectés à une masse commune.

4. Circuit quantique supraconducteur non linéaire (600-630) selon la revendication 3, dans lequel, lorsque les courants sont appliqués au circuit, l'hamiltonien du circuit présente :
- un terme linéaire décrivant le premier mode et le second mode du type *H*ₗᵢₙ = 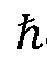 *ωₐa*^{†}*a +* 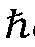 *ω_{b}b*^{†}*b,* où $\frac{{ω}_{a}}{2 π}$ est la fréquence de résonance du premier mode et $\frac{{ω}_{b}}{2 π}$ est la fréquence de résonance du second mode,
- au moins un terme non linéaire de la forme *E_{J}*sin(*φ_{DC}*)sin(*φₐ*((*a*+*a*^{†})*+ε*(*b+b*^{†}))) ou de la forme *E_{J}*sin(*φ_{DC}*)sin(*φ_{b}*((*b+b*^{†})*+ε*(*a+a*^{†}))), où :
- *E_{J}* est l'énergie de la jonction Josephson,
- *φ_{DC}* est la différence de phase à travers la jonction Josephson induite par le courant prédéterminé,
- *φₐ* est la fluctuation de point zéro de la phase à travers la jonction Josephson associée au premier mode et *φ_{b}* est la fluctuation de point zéro de la phase à travers la jonction Josephson associée au second mode, et
- *ε* décrit un couplage linéaire entre le premier et le second mode,
le circuit (600-630) présentant ainsi un hamiltonien, étant extensible en une somme comprenant au moins un terme dominant qui est un terme résonant non linéaire du type ${ℏg}_{2 N} {a}^{2 N} {b}^{†} + {ℏg}_{2 N}^{∗} {a}^{† 2 N} b$ avec ${ℏg}_{2 N} = {E}_{j} sin \left({φ}_{DC}\right) ϵ \frac{{φ}_{a}^{2 N + 1}}{2 N !}$ ou ${ℏg}_{2 N} = {E}_{j} sin \left({φ}_{DC}\right) {ϵ}^{2 N} \frac{{φ}_{b}^{2 N + 1}}{2 N !}$, où la condition de résonance 2*Nωₐ = ω_{b}* est obtenue par l'application des courants.

5. Circuit quantique supraconducteur non linéaire (700) selon la revendication 1 ou 2, dans lequel l'au moins une boucle supraconductrice (710) inclut une jonction Josephson (701), un premier élément inductif (702) et un second élément inductif (703) agencés en une topologie en série, la topologie en série comprenant :
- un premier nœud intérieur connectant un pôle de la jonction Josephson (701) à un pôle du premier élément inductif (702),
- un second nœud intérieur connectant un autre pôle de la jonction Josephson (701) à un pôle du second élément inductif (703),
- un nœud en boucle fermée connectant un autre pôle du premier élément inductif (702) à un autre pôle du second élément inductif (703) ;
l'au moins une boucle supraconductrice étant connectée à une masse commune par l'intermédiaire du nœud en boucle fermée ;
le circuit comprenant également un premier condensateur (704) et un second condensateur (705), où :
- le premier condensateur (704) est connecté en parallèle avec le premier élément inductif (702) entre la masse commune et le premier nœud intérieur de la boucle supraconductrice, et
- le second condensateur (705) est connecté en parallèle avec le second élément inductif (703), entre la masse commune et le second nœud intérieur de la boucle supraconductrice.

6. Circuit quantique supraconducteur non linéaire (700) selon la revendication 5, dans lequel, lorsque les courants sont appliqués au circuit, l'hamiltonien du circuit présente :
- un terme linéaire décrivant le premier mode et le second mode du type *H*ₗᵢₙ = 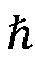 *ωₐa*^{†}*a +* 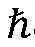 *ω_{b}b*^{†}*b,* où $\frac{{ω}_{a}}{2 π}$ est la fréquence de résonance du premier mode et $\frac{{ω}_{b}}{2 π}$ est la fréquence de résonance du second mode,
- au moins un terme non linéaire de la forme *Eⱼ*sin(*φ_{DC}*)sin(*φₐ*(*a* + *a*^{†}) *+ φ_{b}*(*b + b*^{†})) où :
- *Eⱼ* est l'énergie de la jonction Josephson,
- *φ_{DC}* est la différence de phase à travers la jonction Josephson induite par le courant prédéterminé, et
- *φₐ* est la fluctuation de point zéro de la phase à travers la jonction Josephson associée au premier mode et *φ_{b}* est la fluctuation de point zéro de la phase à travers la jonction Josephson associée au second mode ;
le circuit (700) présentant ainsi un hamiltonien, étant extensible en une somme comprenant au moins un terme dominant qui est un terme résonant non linéaire du type ${ℏg}_{2 N} {a}^{2 N} {b}^{†} + {ℏg}_{2 N}^{∗} {a}^{† 2 N} b$ avec ${ℏg}_{2 N} = \frac{2 {E}_{j} sin \left({φ}_{DC}\right) {φ}_{a}^{2 N} {φ}_{b}}{\left(2N\right) !}$, où la condition de résonance 2*Nωₐ = ω_{b}* est obtenue par l'application des courants.

7. Circuit quantique supraconducteur non linéaire (800) selon la revendication 1 ou 2, dans lequel l'au moins une boucle supraconductrice (810) inclut une première jonction Josephson (801), un élément inductif central (803) et une seconde jonction Josephson (802) agencés en une topologie en série, la topologie en série comprenant :
- un premier nœud intérieur connectant un pôle de la première jonction Josephson (801) à un pôle de l'élément inductif (803),
- un second nœud intérieur connectant un pôle de la seconde jonction Josephson (802) à un autre pôle de l'élément inductif (803),
- un nœud en boucle fermée connectant un autre pôle de la première jonction Josephson (801) à un autre pôle de la seconde jonction Josephson (802) ;
l'au moins une boucle supraconductrice (810) étant connectée à une masse commune par l'intermédiaire du nœud en boucle fermée ;
le circuit (800) comprenant également un premier condensateur (804) et un second condensateur (805), où :
- le premier condensateur (804) est connecté en parallèle avec la première jonction Josephson (801) entre la masse commune et le premier nœud intérieur de la boucle supraconductrice (810), et
- le second condensateur (805) est connecté en parallèle avec la seconde jonction Josephson (802) entre la masse commune et le second nœud intérieur de la boucle supraconductrice (810).

8. Circuit quantique supraconducteur non linéaire (800) selon la revendication 7, dans lequel, lorsque le courant prédéterminé d'une intensité constante est appliqué au circuit, l'hamiltonien du circuit présente :
- un terme linéaire décrivant le premier mode et le second mode du type *H*ₗᵢₙ = ℏ*ωₐa*^{†}*a* + ℏ*ω_{b}b*^{†}*b*, où $\frac{{ω}_{a}}{2 π}$ est la fréquence du premier mode et $\frac{{ω}_{b}}{2 π}$ est la fréquence du second mode,
- au moins un terme non linéaire de la forme *Eⱼ*sin(*φ_{DC}*)cos(*φₐ*(*a*+*a*^{†}))sin(*φ_{b}*+ *b*^{†})) , où :
- *Eⱼ* est l'énergie de la première et/ou de la seconde jonction Josephson,
- *φ*_{*J*0} est la différence de phase à travers la première et/ou la seconde jonction Josephson induite par le courant prédéterminé, et
- *φₐ* est la fluctuation de point zéro de la phase à travers la jonction Josephson associée au premier mode et *φ_{b}* est la fluctuation de point zéro de la phase à travers la jonction Josephson associée au second mode ;
le circuit (800) présentant ainsi un hamiltonien, étant extensible en une somme comprenant au moins un terme dominant qui est un terme résonant non linéaire du type ${ℏg}_{2 N} {a}^{2 N} {b}^{†} + {ℏg}_{2 N}^{∗} {a}^{† 2 N} b$ avec ${ℏg}_{2 N} = 2 {E}_{j} sin \left({φ}_{DC}\right) \frac{{φ}_{a}^{2 N} {φ}_{b}}{\left(2N\right) !}$, où la condition de résonance 2*Nω*ₐ = *ω_{b}* est obtenue par l'application des courants.

9. Dispositif comprenant :
un circuit quantique supraconducteur non linéaire (100, 600, 700, 800) selon l'une quelconque des revendications 1 à 8 ; et
des sources de courant configurées pour appliquer le courant prédéterminé d'une intensité constante au circuit (100, 600, 700, 800) et le courant externe pour polariser le SQUID.

10. Dispositif selon la revendication 9, comprenant en outre :
une charge (105),
une source micro-ondes (106) configurée pour appliquer un rayonnement micro-ondes à une fréquence sensiblement égale à la fréquence de résonance du second mode ou à 2N fois la fréquence de résonance du premier mode,
un coupleur (104) configuré pour coupler le second mode du circuit (100, 600, 700, 800) à la charge (105) et à la source micro-ondes (106) ; et
dans lequel, facultativement :
la charge (105) est soit une résistance, soit une ligne de transmission mise en correspondance, soit un guide d'ondes mis en correspondance,
le dispositif comprend en outre un filtre passe-bande (210) ou coupe-bande (220) connecté au premier et au second mode du circuit (100, 600, 700, 800), le filtre passe-bande (210) ou coupe-bande (220) étant configuré pour permettre uniquement le couplage du second mode à la charge, et/ou
la géométrie et/ou la symétrie du coupleur (104) est telle qu'il se couple uniquement au second mode.

11. Système informatique quantique comprenant au moins un circuit quantique supraconducteur non linéaire (100, 600, 700, 800) selon l'une quelconque des revendications 1 à 8 et/ou un dispositif selon la revendication 9 ou 10.

12. Procédé comprenant :
- la fourniture d'un circuit quantique supraconducteur non linéaire (100, 600, 700, 800) selon l'une quelconque des revendications 1 à 8, un dispositif selon la revendication 9 ou 10, ou un système informatique quantique selon la revendication 11, et
- l'ajustement de l'inductance ajustable respective de chacune de l'une ou des plusieurs jonctions Josephson en appliquant le courant prédéterminé d'une intensité constante au circuit (100, 600, 700, 800) et l'affectation de la fréquence de résonance du second mode en appliquant le courant externe pour polariser le SQUID de sorte que la fréquence de résonance du second mode soit sensiblement 2N fois la fréquence de résonance du premier mode, afin que le circuit réalise l'échange de photons intrinsèquement résonant 2N à 1 entre respectivement le premier mode et le second mode.

13. Procédé selon la revendication 12, dans lequel le procédé comprend la fourniture d'un dispositif selon la revendication 10 ou d'un système informatique quantique comprenant un dispositif selon la revendication 10, le procédé étant utilisé pour stabiliser une variété quantique engendrée par 2N états cohérents d'une même amplitude et d'une différence de phase *π*/*N*, de manière à permettre l'encodage d'informations quantiques sous la forme d'un qubit de chat.
